# EUROPEAN PATENT APPLICATION

(11) **EP 4 509 950 A1**
(43) Date of publication of application: **19.02.2025**
(21) Application number: 24737293.1
(22) Date of filing: 12.06.2024
(51) Int. Cl.: G06F 1/16, H04M 1/02

(54) **HINGE APPARATUS AND ELECTRONIC DEVICE INCLUDING SAME**

(30) Priority: 21.06.2023 KR 20230079947; 25.07.2023 KR 20230096997
(71) Applicant: Samsung Electronics Co., Ltd, Suwon-si, Gyeonggi-do 16677 (KR)
(72) Inventor: CHO, Sunggun, Suwon-si, Gyeonggi-do 16677 (KR); RYU, Myungchul, Suwon-si, Gyeonggi-do 16677 (KR); PARK, Yeongmin, Suwon-si, Gyeonggi-do 16677 (KR); LEE, Dongik, Suwon-si, Gyeonggi-do 16677 (KR); JUNG, Iksu, Suwon-si, Gyeonggi-do 16677 (KR)
(74) Representative: HGF
(86) International application number: PCT/KR2024/008055
(87) International publication number: WO 2024/262866

(57) **Abstract**

According to an embodiment, an electronic device may include a first housing, a second housing, and a hinge device that foldably connect the first housing and the second housing to each other. The hinge device may include a first arm module including a first arm including a first cam structure and a second arm including a second cam structure, and configured to rotate about a first rotation axis, a second arm module including a third arm including a third cam structure and a fourth arm including a fourth cam structure, and configured to rotate about a second rotation axis, a first elastic member located between the first arm and the second arm and configured to press the first arm and the second arm in opposite directions, a second elastic member located between the third arm and the fourth arm and configured to press the third arm and the fourth arm in opposite directions, and a slide bracket including a first cam portion facing the first cam structure, a second cam portion facing the second cam structure, a third cam portion facing the third cam structure, and a fourth cam portion facing the fourth cam structure, and configured to move in response to the first arm module and the second arm module.

## Description

### [Technical Field]

Various embodiments disclosed herein relate to a hinge device and an electronic device including the same.

### [Background Art]

Electronic devices are gradually becoming slimmer to meet consumers' purchasing needs as the functional gap is significantly reduced among respective manufacturers, and are being improved to increase rigidity, strengthen design aspects, and differentiate their functional elements. These electronic devices are gradually being transformed into various shapes, breaking away from the uniform rectangular shape. For example, electronic devices may have a transformable structure that is convenient to carry and enables use of a large screen display when used. As part of this trend, foldable type electronic devices are continuously being released, and operational reliability for frequent folding operations may be required for the foldable type electronic devices.

### [Disclosure of Invention]

### [Technical Problem]

An electronic device may include a foldable electronic device that includes a first housing, a second housing connected (e.g. foldably connected) to the first housing via a hinge device (e.g., a hinge structure, a hinge module, or a hinge assembly). The first housing and the second housing are coupled (e.g. structurally coupled) to the hinge device, thereby ensuring operational reliability for a folded state and/or an unfolded state. This foldable electronic device may be operated in an in-folding and/or out-folding manner by rotating the first housing relative to the second housing within a range of 0 to 360 degrees via the hinge device. The foldable electronic device may include a flexible display disposed across the first housing and the second housing when unfolded at 180 degrees. The folding area of the flexible display can be folded or unfolded together with the electronic device.

The hinge device may include a slide bracket that links the folding operations of the first housing and the second housing. The slide bracket may be configured such that when one of the first housing and the second housing rotates about a folding axis, the other housing also rotates at the same rotation angle as the one housing. For example, the slide bracket may link the rotations of the first arm connected to the first housing and the second arm connected to the second housing so that the first housing and the second housing rotate by the same angle about the folding axis.

Meanwhile, an assembly deviation (e.g. tolerance, gap) may occur on the slide bracket when the slide bracket is connected to the first arm and the second arm. For example, an assembly deviation may occur when the slide bracket and each of the first arm and the second arm are cam-coupled with each other. The assembly deviation may be a tolerance or gap at a portion where the slide bracket and the first arm are fastened and a portion where the slide bracket and the second arm are fastened. Such assembly deviation may deteriorate the feeling of operation when folding or unfolding the electronic device.

According to an embodiment of the disclosure, it is possible to propose a structure that reduces an assembly deviation among components included in a hinge device so as to improve the feeling of operation of the hinge device and to reduce a deviation in linking rotations of the first housing and the second housing. For example, the slide bracket and the plurality of arms may be closely coupled to each other through an elastic member. Therefore, the gap at the portion where the slide bracket and the plurality of arms are coupled can be reduced.

### [Solution to Problem]

According to an embodiment, an electronic device may include a first housing, a second housing, and a hinge device configured to connect (e.g. foldably connect, or foldably couple, or rotatably couple) the first housing and the second housing to each other. The hinge device may include a first arm module including a first arm including a first cam structure and a second arm including a second cam structure, and configured to rotate about a first rotation axis, a second arm module including a third arm including a third cam structure and a fourth arm including a fourth cam structure, and configured to rotate about a second rotation axis, a first elastic member (e.g. a first spring, or a first resilient member) located between the first arm and the second arm and configured to press the first arm and the second arm in opposite directions (in other words, configured to urge the first and second arms apart, away from each other), a second elastic member (e.g. a second spring, or a second resilient member) located between the third arm and the fourth arm and configured to press the third arm and the fourth arm in opposite directions (in other words, configured to urge the third and fourth arms apart, away from each other), and a slide bracket including a first cam portion facing the first cam structure, a second cam portion facing the second cam structure, a third cam portion facing the third cam structure, and a fourth cam portion facing the fourth cam structure, and configured to move in response to the first arm module and the second arm module (e.g. configured to move in response to rotation (or movement) of the first arm module and the second arm module). Thus, in certain embodiments, the first cam structure and second cam structure face in opposite directions, the first cam structure and second cam structure are disposed between the first cam portion and the second cam portion of the slide bracket, and the first elastic member is arranged to urge the first cam structure into contact with (or against) the first cam portion and urge the second cam structure into contact with (or against) the second cam portion. Similarly, in certain embodiments, the third cam structure and fourth cam structure face in opposite directions, the third cam structure and fourth cam structure are disposed between the third cam portion and the fourth cam portion of the slide bracket, and the second elastic member is arranged to urge the third cam structure into contact with (or against) the third cam portion and urge the fourth cam structure into contact with (or against) the fourth cam portion. **In** certain embodiments, the slide bracket (which may also be referred to as a bracket, or bracket member) may be a single component (i.e. as opposed to an assembly of a plurality of components), and this may help reduce the number of operations involved in the assembly of the device.

According to an embodiment, a hinge device, which foldably interconnects a first housing and a second housing of an electronic device, may include a first arm module including a first arm including a first cam structure and a second arm including a second cam structure, and configured to rotate about a first rotation axis, a second arm module including a third arm including a third cam structure and a fourth arm including a fourth cam structure, and configured to rotate about a second rotation axis, a first elastic member located between the first arm and the second arm and configured to press the first arm and the second arm in opposite directions, a second elastic member located between the third arm and the fourth arm and configured to press the third arm and the fourth arm in opposite directions, and a slide bracket including a first cam portion facing the first cam structure, a second cam portion facing the second cam structure, a third cam portion facing the third cam structure, and a fourth cam portion facing the fourth cam structure, and configured to move in response to the first arm module and the second arm module. The first cam structure and the second cam structure of the first arm module may be pressed toward the first cam portion and the second cam portion, respectively, via the first elastic member, and the third cam structure and the fourth cam structure of the second arm module may be pressed toward the third cam portion and the fourth cam portion, respectively, via the first elastic member.

### [Advantageous Effects of Invention]

According to an embodiment of the disclosure, it is possible to propose a structure that reduces an assembly deviation among components included in a hinge device so as to improve the feeling of operation of the hinge device and to reduce a deviation in linking rotations of the first housing and the second housing (or, in other words, make the rotational movement of one housing more closely linked, or even the same as, the rotational movement of the other). The assembly deviation may be a tolerance or gap between a portion where the slide bracket and the first arm module are fastened and a portion where the slide bracket and the second arm module are fastened. In one embodiment, the first arm module may include a first arm having a first cam structure and a second arm having a second cam structure. The first cam structure and the second cam structure are disposed between the first cam portion and the second cam portion of the slide bracket and face in opposite directions. Depending on the folding state of the hinge device, the first cam structure of the first arm is in close contact with the first cam portion of the slide bracket through the elastic member. Additionally, the second cam structure of the second arm is in close contact with the second cam portion of the slide bracket through the elastic member. Accordingly, the assembly deviation (e.g., tolerance, gap) between the first cam structure and the first cam portion and/or the assembly deviation (e.g., tolerance, gap) between the second cam structure and the second cam portion may be reduced. Likewise, the second arm module include a third arm having a third cam structure and a fourth arm having a fourth cam structure. The third cam structure and the fourth cam structure are disposed between the third cam portion and the fourth cam portion of the slide bracket and face in opposite directions. Depending on the folding state of the hinge device, the third cam structure of the third arm is in close contact with the third cam portion of the slide bracket through the elastic member. Additionally, the fourth cam structure of the fourth arm is in close contact with the fourth cam portion of the slide bracket through the elastic member. Accordingly, the assembly deviation (e.g., tolerance, gap) between the third cam structure and the third cam portion and/or the assembly deviation (e.g., tolerance, gap) between the fourth cam structure and the fourth cam portion may be reduced. Accordingly, the feeling of operation of the hinge device can be improved, and the deviation in linking rotations of the first housing and the second housing can be reduced.

### [Brief Description of Drawings]

In connection with the description of the drawings, the same or similar components may be denoted by the same or similar reference numerals.
FIGS. 1A and 1B are a front view and a rear view of an electronic device according to an embodiment of the disclosure in an unfolded state.
FIGS. 2A and 2B are a front view and a rear view of the electronic device according to an embodiment of the disclosure in a folded state.
FIG. 3 is an exploded perspective view illustrating an electronic device according to an embodiment of the disclosure.
FIG. 4A is a perspective view of a hinge device according to an embodiment of the disclosure in which a first arm link of the hinge device is slidably connected to a first arm module and a second arm link is slidably connected to a second arm module.
FIG. 4B is a perspective view of a hinge device according to an embodiment of the disclosure in which a first arm link of the hinge device is rotatably connected to a first arm module and a second arm link is rotatably connected to a second arm module.
FIG. 5 is an exploded perspective view of a hinge device according to an embodiment of the disclosure.
FIG. 6A is an exploded perspective view of a first arm module, a second arm module, and a slide bracket according to an embodiment of the disclosure.
FIG. 6B is a view illustrating the linked relationship among the slide bracket, the first arm module, and the second arm module according to an embodiment of the disclosure illustrated in FIGS. 4A and 4B.
FIG. 6C is a perspective view of the slide bracket according to an embodiment of the disclosure.
FIG. 6D is a front view of the slide bracket according to an embodiment of the disclosure.
FIG. 6E illustrates cross-sectional views of the slide bracket taken along lines D-D and E-E indicated in FIG. 6D.
FIGS. 7A and 7B are views illustrating the coupling relationship between the first arm and the second arm.
FIGS. 8A and 8B are diagrams illustrating the coupling relationship between a first rotator and a second rotator.
FIG. 9A is a cross-sectional view of the hinge device taken along line A-A indicated in FIG. 4A when the electronic device is in the unfolded state.
FIG. 9B is a cross-sectional view of the hinge device taken along line A-A indicated in FIG. 4A when the electronic device is in the intermediate state.
FIG. 9C is a cross-sectional view of the hinge device taken along line A-A indicated in FIG. 4A when the electronic device is in the folded state.
FIG. 10A is a cross-sectional view of the hinge device taken along line B-B indicated in FIG. 4A when the electronic device is in the unfolded state.
FIG. 10B is a cross-sectional view of the hinge device taken along line B-B indicated in FIG. 4A when the electronic device is in the intermediate state.
FIG. 10C is a cross-sectional view of the hinge device taken along line B-B indicated in FIG. 4A when the electronic device is in the folded state.
FIG. 11A is a cross-sectional view of the hinge device taken along line C-C indicated in FIG. 4B when the electronic device is in the unfolded state.
FIG. 11B is a cross-sectional view of the hinge device taken along line C-C indicated in FIG. 4B when the electronic device is in the intermediate state.
FIG. 11C is a cross-sectional view of the hinge device taken along line C-C indicated in FIG. 4A when the electronic device is in the folded state.

### [Mode for the Invention]

It should be appreciated that various embodiments of the present disclosure and the terms used therein are not intended to limit the technological features set forth herein to particular embodiments and include various changes, equivalents, or replacements for a corresponding embodiment.

With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

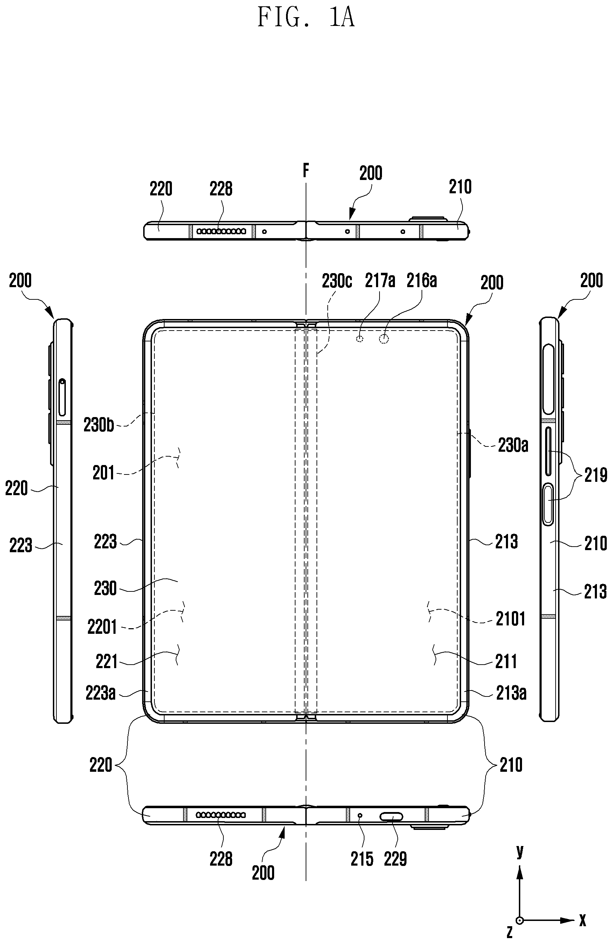

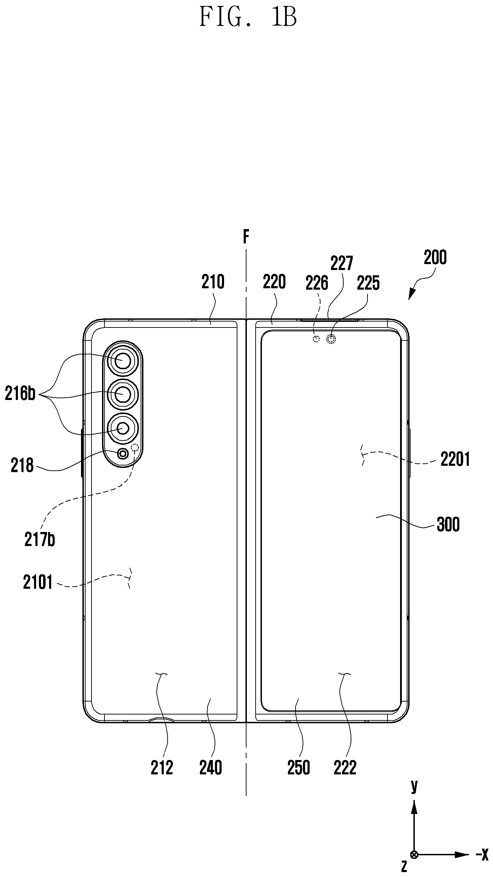

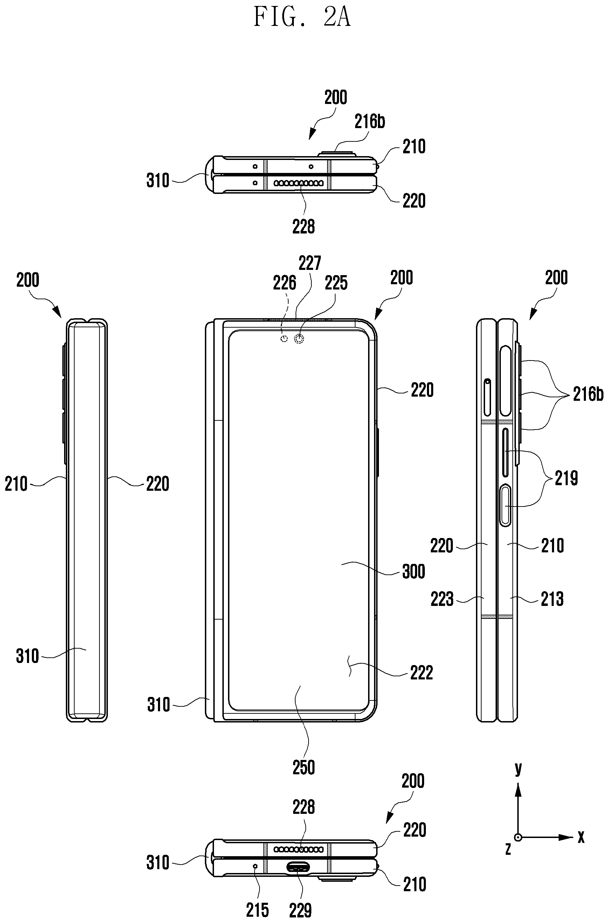

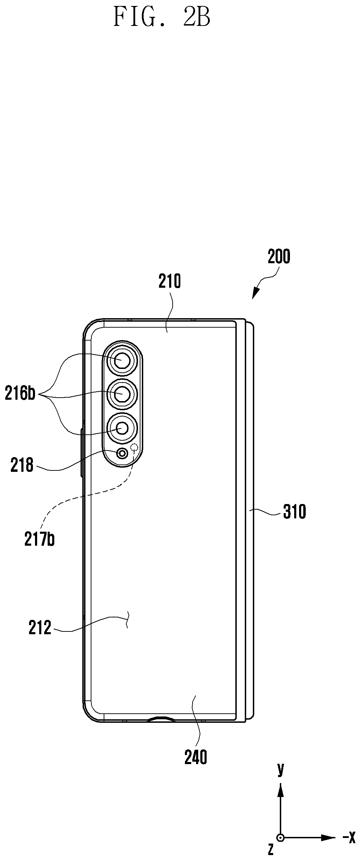

FIGS. 1A and 1B illustrate a front view and a rear view of an unfolded stateof an electronic device according to various embodiments of the disclosure. FIGS. 2A and 2B illustrate a front view and a rear view of a folded state of an electronic device according to various embodiments of the disclosure.

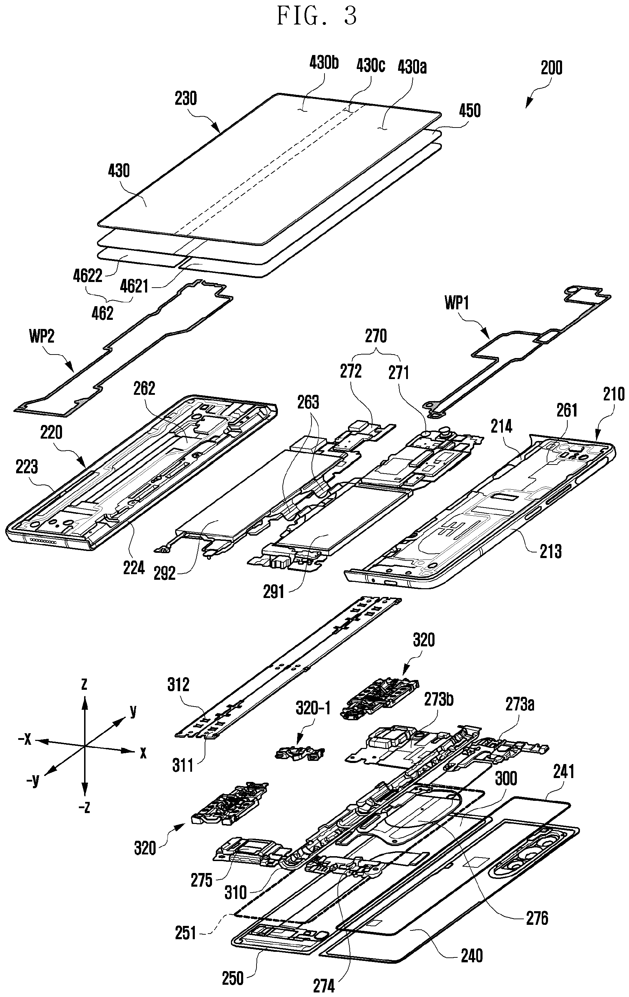

Referring to FIGS. 1A to 2B, an electronic device 200 may include a pair of housings 210 and 220 (e.g., a foldable housing structure) rotatably coupled to each other with reference to folding axis F through at least one hinge device (e.g., a hinge device 320 of FIG. 3) (e.g., a hinge module) so as to be folded with respect to each other, a first display 230 (e.g., a flexible display, a foldable display, or a main display) disposed through the pair of housings 210 and 220, and/or a second display 300 (e.g., a sub display) disposed through the second housing 220. According to an embodiment, at least a part of the hinge device (e.g., the hinge device 320 of FIG. 3) may be disposed so as not to be seen from the outside through the first housing 210 and the second housing 220, and may be disposed so as not to be seen from the outside through the hinge housing 310 covering a foldable portion. In the disclosure, a surface in which the first display 230 is disposed may be defined as a front surface of the electronic device 200, and a surface opposite to the front surface may be defined as a rear surface of the electronic device 200. In addition, a surface surrounding a space between the front surface and the rear surface may be defined as a side surface of the electronic device 200.

According to various embodiments, the pair of housings 210 and 220 may include a first housing 210 and a second housing 220 foldably arranged with respect to each other through the hinge device (e.g., the hinge device 320 of FIG. 3). According to an embodiment, the shape and the coupling of the pair of housings 210 and 220 are not limited to those illustrated in FIGS. 1A to 2B, and the pair of housings 210 and 220 may be implemented by a combination and/or coupling of other shapes or components. According to an embodiment, the first housing 210 and the second housing 220 may be arranged on opposite sides with reference to the folding axis F, and may have shapes that are entirely symmetric to each other with respect to the folding axis F. According to an embodiment, the first housing 210 and the second housing 220 may be asymmetrically folded with reference to the folding axis F. According to an embodiment, the angle or the distance between the first housing 210 and the second housing 220 may vary depending on whether the electronic device 200 is in an unfolded state, a folded state, or an intermediate state.

According to various embodiments, the first housing 210 may include, in the unfolded state of the electronic device 200, a first surface 211 connected to the hinge device (e.g., the hinge device 320 of FIG. 3) and disposed to be oriented to the front surface of the electronic device 200, a second surface 212 oriented in a direction opposite to the first surface 211, and/or a first side member 213 surrounding at least a part of a first space 2101 between the first surface 211 and the second surface 212. According to an embodiment, the second housing 220 may include, in the unfolded state of the electronic device 200, a third surface 221 connected to the hinge device (e.g., the hinge device 320 of FIG. 3) and disposed to be oriented to the front surface of the electronic device 200, a fourth surface 222 oriented in a direction opposite to the third surface 221, and/or a second side member 223 surrounding at least a part of a second space 2201 between the third surface 221 and the fourth surface 222. According to an embodiment, the first surface 211 and the third surface 221 may be oriented in substantially the same direction in the unfolded state, and the first surface 211 and the third surface 221 may at least partially face each other in the folded state. According to an embodiment, the electronic device 200 may include a recess 201 formed to receive the first display 230 through structural coupling of the first housing 210 and the second housing 220. According to an embodiment, the recess 201 may have substantially the same shape as the first display 230. According to an embodiment, the first housing 210 may include a first protection frame 213a (e.g., a first decoration member) which is, when seen from above the first display 230, coupled to the first side member 213, disposed to overlap with an edge of the first display 230, so as to cover the edge of the first display 230 to allow the same not to be seen from the outside. According to an embodiment, the first protection frame 213a may be integrally formed with the first side member 213. According to an embodiment, the second housing 220 may include a second protection frame 223a (e.g., a second decoration member) which is, when seen from above the first display 230, coupled to the second side member 223, disposed to overlap with an edge of the first display 230, so as to cover the edge of the first display 230 to allow the same not to be seen from the outside. According to an embodiment, the second protection frame 223a may be integrally formed with the second side member 223. In an embodiment, the first protection frame 213a and the second protection frame 223a may be omitted.

According to various embodiments, the hinge housing 310 (e.g., a hinge cover) may be disposed between the first housing 210 and the second housing 220, and may be disposed to cover a part (e.g., at least one hinge module) of the hinge device (e.g., the hinge device 320 of FIG. 3) disposed on the hinge housing 310. According to an embodiment, the hinge housing 310 may be hidden or exposed from or to the outside by a part of the first housing 210 and the second housing 220 according to the unfolded state, the folded state, or the intermediate state of the electronic device 200. For example, when the electronic device 200 is in the unfolded state, at least a part of the hinge housing 310 may be covered by the first housing 210 and the second housing 220 and not be substantially exposed. According to an embodiment, when the electronic device 200 is in the folded state, at least a part of the hinge housing 310 may be exposed to the outside between the first housing 210 and the second housing 220. According to an embodiment, in the intermediate state in which the first housing 210 and the second housing 220 are folded with each other by a predetermined angle (folded with a certain angle), the hinge housing 310 may be at least partially exposed to the outside of the electronic device 200 between the first housing 210 and the second housing 220. For example, an area in which the hinge housing 310 is exposed to the outside, may be smaller than that in a case in which the electronic device 200 is completely folded. According to an embodiment, the hinge housing 310 may include a curved surface.

According to various embodiments, when the electronic device 200 is in the unfolded state (e.g., the states shown in FIGS. 1A and 1B), the first housing 210 and the second housing 220 may meet at an about 180-degree angle, and a first area 230a, a second area 230b, and a folding area 230c of the first display 230 may form the same plane and arranged to be oriented in substantially the same direction (e.g., a z-axis direction). **In** another embodiment, when the electronic device 200 is in the unfolded state, the first housing 210 may rotate by an about 360-degree angle with respect to the second housing 220, and may be outwardly folded (an out-folding scheme) so that the second surface 212 and the fourth surface 222 face each other.

According to various embodiments, when the electronic device 200 is in the folded state (e.g., the states shown in FIGS. 2A and 2B), the first surface 211 of the first housing 210 and the third surface 221 of the second housing 220 may be arranged to face each other. **In** this case, the first area 230a and the second area 230b of the first display 230 may form a narrow angle (e.g., a range between 0 degree to about 10 degrees) through the folding area 230c, and may be arranged to face each other. According to an embodiment, at least a part of the folding area 230c may be deformed into a curved shape having a predetermined curvature. According to an embodiment, when the electronic device 200 is in the intermediate state, the first housing 210 and the second housing 220 may be arranged at a predetermined angle (a certain angle). **In** this case, the first area 230a and the second area 230b of the first display 230 may form an angle that is greater than that in the folded state and smaller than that in the unfolded state, and the curvature of the folding area 230c may be lower than that in the folded state, and may be higher than that in the unfolded state. **In** an embodiment, the first housing 210 and the second housing 220 may form an angle which allows stopping at a designated folding angle between the folded state and the unfolded state (a free stop function), through the hinge device (e.g., the hinge device 320 of FIG. 3). In an embodiment, the first housing 210 and the second housing 220 may continuously operate while being pressed in an unfolding direction or a folding direction with reference to a designated inflection angle, through the hinge device (e.g., the hinge device 320 of FIG. 3).

According to various embodiments, the electronic device 200 may include at least one of at least one display 230 and 300 disposed on the first housing 210 and/or the second housing 220, an input device 215, sound output devices 227 and 228, sensor modules 217a, 217b, and 226, camera modules 216a, 216b, and 225, a key input device 219, an indicator (not shown), or a connector port 229. In an embodiment, the electronic device 200 may omit at least one of the elements, or may additionally include at least one another element.

According to various embodiments, the at least one display 230 and 300 may include a first display 230 (e.g., a flexible display) disposed to be supported by the third surface 221 of the second housing 220 from the first surface 211 of the first housing 210 through the hinge device (e.g., the hinge device 320 of FIG. 3), and a second display 300 disposed to be at least partially seen from the outside through the fourth surface 222 in a space in the second housing 220. In an embodiment, the second display 300 may be disposed to be seen from the outside through the second surface 212 in a space in the first housing 210. According to an embodiment, the first display 230 may be mainly used in the unfolded state of the electronic device 200, and the second display 300 may be mainly used in the folded state of the electronic device 200. According to an embodiment, the electronic device 200 may control, in the intermediate state, the first display 230 and/or the second display 300 to be used, based on a folding angle between the first housing 210 and the second housing 220.

According to various embodiments, the first display 230 may be disposed in a receiving space formed by the pair of housings 210 and 220. For example, the first display 230 may be disposed in a recess 201 formed by the pair of housings 210 and 220, and may be disposed to occupy substantially the most of the front surface of the electronic device 200in the unfolded state. According to an embodiment, the first display 230 may include a flexible display having at least one area which can be deformed into a plane or a curved surface. According to an embodiment, the first display 230 may include the first area 230a facing the first housing 210 and the second area 230b facing the second housing 220. According to an embodiment, the first display 230 may include the folding area 230c including a part of the first area 230a and a part of the second area 230b with respect to the folding axis F. According to an embodiment, at least a part of the folding area 230c may include an area corresponding to the hinge device (e.g., the hinge device 320 of FIG. 3). According to an embodiment, a division of an area of the first display 230 merely corresponds to exemplary physical division by the pair of housings 210 and 220 and the hinge device (e.g., the hinge device 320 of FIG. 3), and the first display 230 may be substantially displayed as one seamless full screen through the pair of the housings 210 and 220 and the hinge device (e.g., the hinge device 320 of FIG. 3). According to an embodiment, the first area 230a and the second area 230b may have shapes that are entirely symmetric or partially asymmetric to each other with respect to the folding area 230c.

According to various embodiments, the electronic device 200 may include a first rear cover 240 disposed on the second surface 212 of the first housing 210 and a second rear cover 250 disposed on the fourth surface 222 of the second housing 220. In an embodiment, at least a part of the first rear cover 240 may be integrally formed with the first side member 213. In an embodiment, at least a part of the second rear cover 250 may be integrally formed with the second side member 223. According to an embodiment, at least one of the first rear cover 240 and the second rear cover 250 may be substantially formed of a transparent plate (e.g., a polymer plate or glass plate including various coding layers) or an opaque plate. According to an embodiment, the first rear cover 240 may be formed of, for example, an opaque plate such as coded or colored glass, ceramic, polymer, metal (e.g., aluminum, stainless steel (STS), or magnesium), or a combination of at least two of the materials above. According to an embodiment, the second rear cover 250 may be substantially formed of, for example, a transparent plate such as glass or polymer. Accordingly, the second display 300 may be disposed to be seen from the outside through the second rear cover 250 in a space in the second housing 220.

According to various embodiments, the input device 215 may include a microphone. In an embodiment, the input device 215 may include multiple microphones arranged to detect the direction of sound. According to an embodiment, the sound output devices 227 and 228 may include speakers. According to an embodiment, the sound output devices 227 and 228 may include a call receiver 227 disposed through the fourth surface 222 of the second housing 220 and an external speaker 228 disposed through at least a part of the second side member 223 of the second housing 220. In an embodiment, the input device 215, the sound output devices 227 and 228, and the connector port 229 may be disposed in spaces of the first housing 210 and/or the second housing 220, and may be exposed to an external environment through at least one hole formed through the first housing 210 and/or the second housing 220. In an embodiment, holes formed through the first housing 210 and/or the second housing 220 may be commonly used for the input device 215 and the sound output devices 227 and 228. In an embodiment, the sound output devices 227 and 228 may include a speaker (e.g., a piezo speaker) operating without including a hole formed through the first housing 210 and/or the second housing 220.

According to various embodiments, the camera modules 216a, 216b, and 225 may include a first camera module 216a disposed on the first surface 211 of the first housing 210, a second camera module 216b disposed on the second surface 212 of the first housing 210, and/or a third camera module 225 disposed on the fourth surface 222 of the second housing 220. According to an embodiment, the electronic device 200 may include a flash 218 disposed around the second camera module 216b. According to an embodiment, the flash 218 may include, for example, a light-emitting diode or a xenon lamp. According to an embodiment, the camera modules 216a, 216b, and 225 may include one or multiple lenses, an image sensor, and/or an image signal processor. In an embodiment, at least one of the camera modules 216a, 216b, and 225 may include two or more lenses (e.g., wide-angle and telephoto lenses) and image sensors, and may be arranged together on one surface of the first housing 210 and/or the second housing 220.

According to various embodiments, the sensor modules 217a, 217b, and 226 may generate a data value or an electrical signal corresponding to an internal operational state or an external environmental state of the electronic device 200.According to an embodiment, the sensor modules 217a, 217b, and 226 may include a first sensor module 217a disposed on the first surface 211 of the first housing 210, a second sensor module 217b disposed on the second surface 212 of the first housing 210, and/or a third sensor module 226 disposed on the fourth surface 222 of the second housing 220. In an embodiment, the sensor modules 217a, 217b, and 226 may include at least one of a gesture sensor, a grip sensor, a color sensor, an infrared (IR) sensor, an illuminance sensor, an ultrasonic sensor, an iris recognition sensor, or a distance detection sensor (e.g., a time of flight (TOF) sensor or a light detection and ranging (LiDAR)).

According to various embodiments, the electronic device 200 may further include an unillustrated sensor module, for example, at least one of an atmospheric sensor, a magnetic sensor, a biometric sensor, a temperature sensor, a humidity sensor, or a fingerprint recognition sensor. In an embodiment, the fingerprint recognition sensor may be disposed through at least one of the first side member 213 of the first housing 210 and/or the second side member 223 of the second housing 220.

According to various embodiments, the key input device 219 may be disposed to be exposed to the outside through the first side member 213 of the first housing 210. In an embodiment, the key input device 219 may be disposed to be exposed to the outside through the second side member 223 of the second housing 220. In an embodiment, the electronic device 200 may not include some or all of the key input device 219, and the unincluded key input device 219 may be implemented in another shape such as a soft key on the least one display 230 and 300. In another embodiment, the key input device 219 may be implemented by using a pressure sensor included in the at least one display 230 and 300.

According to various embodiments, the connector port 229 may include a connector (e.g., a USB connector or an IF module (an interface connector port module)) for transmitting or receiving data and/or power to and/or from an external electronic device. In an embodiment, the connector port 229 may perform a function of transmitting or receiving an audio signal to or from the external electronic device together, or may further include a separate connector port (e.g., an ear jack hole) for performing a function of transmitting or receiving an audio signal to or from the external electronic device.

According to various embodiments, at least one camera modules 216a and 225 of the camera modules 216a, 216b, and 225, at least one sensor module 217a and 226 of the sensor modules 217a, 217b, and 226, and/or an indicator may be arranged to be exposed through the at least one display 230 and 300. For example, the at least one camera modules 216a and 225, the at least one sensor module 217a and 226, and/or the indicator may be arranged under an activated area (a display area) of the at least one display 230 and 300 in a space in the at least one housing 210 and 220, and may be arranged to come into contact with an external environment through a transparent area or an opening that is perforated to a cover member (e.g., a window layer (not shown) of the first display 230 and/or the second rear cover 250). According to an embodiment, an area in which the at least one display 230 and 300 and the at least one camera module 216a and 225 face each other may be formed as a transmission area having a predetermined transmission ratio, as a part of an area in which a content is displayed. According to an embodiment, the transmission area may be formed to have a transmission ratio in the range of about 5% to about 20%. The transmission area may include an area overlapping with an effective area (e.g., an angle of view area) of the at least one camera module 216a and 225, wherein an image is formed on the image sensor in the effective area, and light for generating an image passes through the effective area. For example, the transmission area of the display 230 and 300 may include an area in which the density of a pixel is lower than that in a surrounding area. For example, the transmission area may be replaced with an opening. For example, the at least one camera module 216a and 225 may include an under-display camera (UDC) or an under-panel camera (UPC). In another embodiment, some camera modules or sensor modules 271a and 226 may be arranged to perform functions thereof without being visually exposed through the display. For example, an area facing the sensor module 217a and 226 and/or the camera module 216a and 225 arranged under the display 230 and 300 (e.g., a display panel) corresponds to an under-display camera (UDC) structure, and a perforated opening is not necessarily required.

FIG. 3 is an exploded perspective view of the electronic device according to various embodiments of the disclosure.

Referring to FIG. 3, an electronic device 200 may include a first display 230 (e.g., a flexible display), a second display 300, one or more hinge apparatuses 320, a pair of support members 261 and 262, one or more substrates 270 (e.g., a printed circuit board (PCB)), a first housing 210, a second housing 220, a first rear surface cover 240, and/or a second rear surface cover 250.

According to various embodiments, the first display 230 may include a display panel 430 (e.g., a flexible display panel) and a support plate 450 disposed below the display panel 430. In an embodiment, the first display 230 may include a reinforcing plate 462 disposed below the support plate 450. In some embodiments, the reinforcing plate 462 may be omitted. In an embodiment, the display panel 430 may include a first panel area 430a corresponding to a first area (e.g., the first area 230a in FIG. 1A) of the first display 230, a second panel area 430b extending from the first panel area 430a and corresponding to a second area (e.g., the second area 230b in FIG. 1) of the first display 230, and a third panel area 430c interconnecting the first panel area 430a and the second panel area 430b and corresponding to a folding area (e.g., the folding area 230c in FIG. 1A) of the first display 230. In an embodiment, the support plate 450 is disposed between the display panel 430 and a pair of support members 261 and 262 and may be configured to have a material and a shape to provide a flat support structure for the first panel area 430a and the second panel area 430b and a bendable structure for helping bendability of the third panel area 430c. In an embodiment, the support plate 450 may be formed of a conductive material (e.g., metal) or a non-conductive material (e.g., polymer or fiber reinforced plastics (FRP)). In an embodiment, the reinforcing plate 462 may include, between the support plate 450 and a pair of support members 261 and 262, a first reinforcing plate 4621 disposed to correspond to the first panel area 430a and at least a portion of the third panel area 430c, and a second reinforcing plate 4622 disposed to correspond to the second panel area 430b and at least a portion of the third panel area 430c. In an embodiment, the reinforcing plate 462 is formed of a metal material (e.g., SUS) to help reinforce a ground connection structure and rigidity for the first display 230. In some embodiments, the electronic device 200 may include a digitizer disposed below the support plate 450 in replacement for the support plate 462 or added between the support plate 450 and the reinforcing plate 462.

According to various embodiments, the second display 300 may be disposed in a space between the second housing 220 and the second rear surface cover 250. In an embodiment, the second display 300 may be disposed in the space between the second housing 220 and the second rear surface cover 250 to be visible from the outside through substantially the entire area of the second rear surface cover 250.

According to various embodiments, at least a portion of the first support member 261 may be coupled to the second support member 262 to be foldable via the one or more hinge apparatuses 320. **In** an embodiment, the electronic device 200 may include one or more wiring members 263 (e.g., a flexible printed circuit board (FPCB)) extending from at least a portion of the first support member 261 to a portion of the second support member 262 across the one or more hinge apparatuses 320. In an embodiment, the first support member 261 may extend from a first side surface member 213 or may be disposed in a manner of being structurally coupled with the first side surface member 213. In an embodiment, the electronic device 200 may include a first space (e.g., the first space 2101 of FIG. 1A) provided by the first support member 261 and the first rear surface cover 240. In an embodiment, the first housing 210 (e.g., a first housing structure) may be configured through the assembly of the first side surface member 213, the first support member 261, and the first rear surface cover 240. In an embodiment, the second support member 262 may extend from a second side surface member 223 or may be disposed in a manner of being structurally coupled with the second side surface member 223. In an embodiment, the electronic device 200 may include a second space (e.g., the second space 2201 of FIG. 1A) provided by the second support member 262 and the second rear surface cover 250. In an embodiment, the second housing 220 (e.g., a second housing structure) may be configured through the assembly of the second side surface member 223, the second support member 262, and the second rear surface cover 250. In an embodiment, the one or more wiring members 263 and/or the one or more hinge apparatuses 320 may be disposed to be at least partially supported by at least a portion of the pair of support members 261 and 262. In an embodiment, the one or more wiring members 263 may be disposed to extend from the first support member 261 to the second support member 262 across a folding axis F. In an embodiment, the one or more wiring members 263 may be disposed to have a length in a direction (e.g., the x-axis direction) substantially perpendicular to the folding axis (e.g., the y-axis or the folding axis F of FIG. 1A).

According to various embodiments, the one or more substrates 270 may include a first substrate 271 disposed in the first space 2101 and a second substrate 272 disposed in the second space 2201. In an embodiment, the first substrate 271 and the second substrate 272 may include a plurality of electronic components arranged to implement various functions of the electronic device 200. In an embodiment, the first substrate 271 and the second substrate 272 may be electrically connected to each other via the one or more wiring members 263.

According to various embodiments, the electronic device 200 may include one or more batteries 291 and 292. In an embodiment, the one or more batteries 291 and 292 may include a first battery 291 disposed in the first space 2101 of the first housing 210 and electrically connected to the first substrate 271 and a second battery disposed in the second space 2201 of the second housing 220 and electrically connected to the second substrate 272. In an embodiment, the first support member 261 and the second support member 262 may further include one or more swelling holes for the first battery 291 and the second battery 292.

According to various embodiments, the first housing 210 may include a first rotation support surface 214, and the second housing 220 may include a second rotation support surface 224, which corresponds to the first rotation support surface 214. In an embodiment, the first rotation support surface 214 and the second rotation support surface 224 may each include a curved surface corresponding to (naturally connected to) the curved outer surface of the hinge housing 310. In an embodiment, when the electronic device 200 is in the unfolded state, the first rotation support surface 214 and the second rotation support surface 224 may cover the hinge housing 310 such that a hinge housing 310 cannot be exposed to the rear surface of the electronic device 200 or can be only partially exposed to the rear surface of the electronic device 200. In an embodiment, when the electronic device 200 is in the folded state, the first rotation support surface 214 and the second rotation support surface 224 may rotate along the curved outer surface of the hinge housing 310 to at least partially expose the hinge housing 310 to the rear surface of the electronic device 200.

According to various embodiments, the electronic device 200 may include one or more antennas 276 disposed in the first space 2101. In an embodiment, the one or more antennas 276 may be disposed on the first battery 291 and the first rear surface cover 240 in the first space 2101. In an embodiment, the one or more antennas 276 may include, for example, a near-field communication (NFC) antenna, a wireless charging antenna, and/or a magnetic secure transmission (MST) antenna. In an embodiment, the one or more antennas 276 may execute, for example, short-range communication with an external device or wireless transmission/reception of power required for charging. In some embodiments, antenna structures may be configured by at least a portion of the first side surface member 213 or the second side surface member 223 and/or a portion of the first support member 261 and the second support member 262 or a combination thereof.

According to various embodiments, the electronic device 200 may further include one or more electronic component assemblies 274 and 275 and/or additional support members 273a and 273b disposed in a first space (e.g., the first space 2101 of FIG. 1A) and/or a second space (e.g., the second space 2201 of FIG. 1A). For example, the one or more electronic component assemblies may include an interface connector port assembly 274 or a speaker assembly 275.

According to various embodiments, the electronic device 200 may include a first waterproof member WP1 disposed between the first reinforcing plate 4621 and the first support member 261 and a second waterproof member WP2 disposed between the second reinforcing plate 4622 and the second support member 262. In an embodiment, the first waterproof member WP1 may provide at least one first waterproof space between the first reinforcing plate 4621 and the first support member 261. In an embodiment, the at least one first waterproof space may accommodate an area corresponding to at least one electronic component (e.g., a camera module or a sensor module) disposed to be supported by the first support member 261. In an embodiment, the second waterproof member WP2 may provide a second waterproof space between the second reinforcing plate 4622 and the second support member 262. In an embodiment, the second waterproof space may accommodate at least a portion of the bending portion folded to the rear surface of the first display 230.

According to various embodiments, the electronic device 200 may include a waterproof tape 241 disposed between the first rear surface cover 240 and the first housing 210. In an embodiment, the electronic device 200 may include a bonding member 251 disposed between the second rear surface cover 250 and the second housing 220. In some embodiments, the bonding member 251 may be disposed between the second display 300 and the second housing 220. In some embodiments, the waterproof tape 241 may be replaced with the bonding member 251, and the bonding member 251 may be replaced with the waterproof tape 241.

According to an embodiment, the at least one hinge device 320 may include a pair of hinge devices 320 disposed at opposite ends in a direction parallel to a folding axis F. In some embodiments, three or more hinge devices 320 may be arranged at a predetermined interval along the folding axis F, or one hinge device 320 may be arranged along the folding axis F1. In an embodiment, the electronic device 200 may include a connection module 320-1 disposed between the hinge devices 320. In an embodiment, the connection module 320-1 may be disposed through a combination of one or more gears and/or a combination of one or more links. In some embodiments, the connection module 320-1 may be replaced with the hinge devices 320. In an embodiment, the electronic device 200 may include a first hinge plate 311 and a second hinge plate 312 connected via one or more hinge devices 320. In an embodiment, in the unfolded state, the first hinge plate 311 may form the same plane as the first housing 210, and, in the unfolded state, the second hinge plate 312 may form the same plane as the second housing 220. According to an embodiment, the flexible display 230 may be transformed into a waterdrop shape and accommodated in the internal space of the electronic device 200 through the one or more hinge devices 320 and 320-1 when the electronic device 200 is in the folded state. According to an embodiment, in the folded state, the first hinge plate 311 and the second hinge plate 312 may be moved to support at least a portion of the transformed waterdrop-shaped folding area (e.g., the folding area 230C in FIG. 1A) of the flexible display, and in the folded state, the first housing 210 and the second housing 220 may be moved to support untransformed flat portions (e.g., the first area 230a and the second area 230b of FIG. 1A) of the flexible display 230. Accordingly, the first hinge plate 311 may not form the same plane as the first housing 210 in the folded state, and the second hinge plate 312 may not form the same plane as the second housing 220. According to an embodiment of the disclosure, the one or more hinge devices 320 or 320-1 may guide the folding area 230c to be transformed into a predetermined shape (e.g., a waterdrop shape) in the folded state of the flexible display 230. For example, the folding area 230c of the flexible display can be transformed into a curved shape only when the hinge devices 320 and 320-1 should be designed to rotate about rotation axes (e.g., a first rotation axis X1 of a first rotator, a second rotation axis X2 of a second rotator, a fifth rotation axis X5 of a first rotator link, and a sixth rotation axis X6 of a second rotator link) which rotate about positions different from the folding axis F of the flexible display 230.

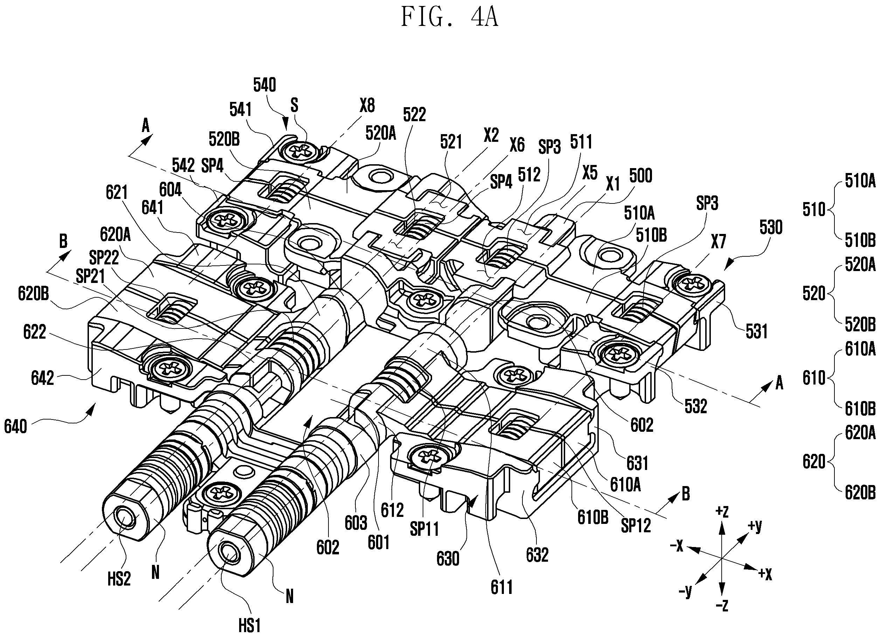

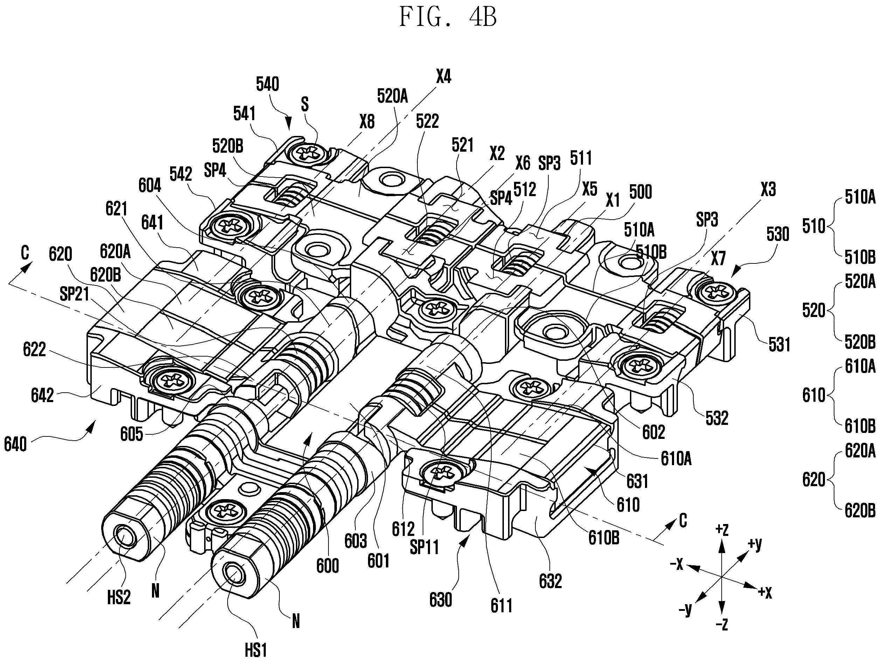

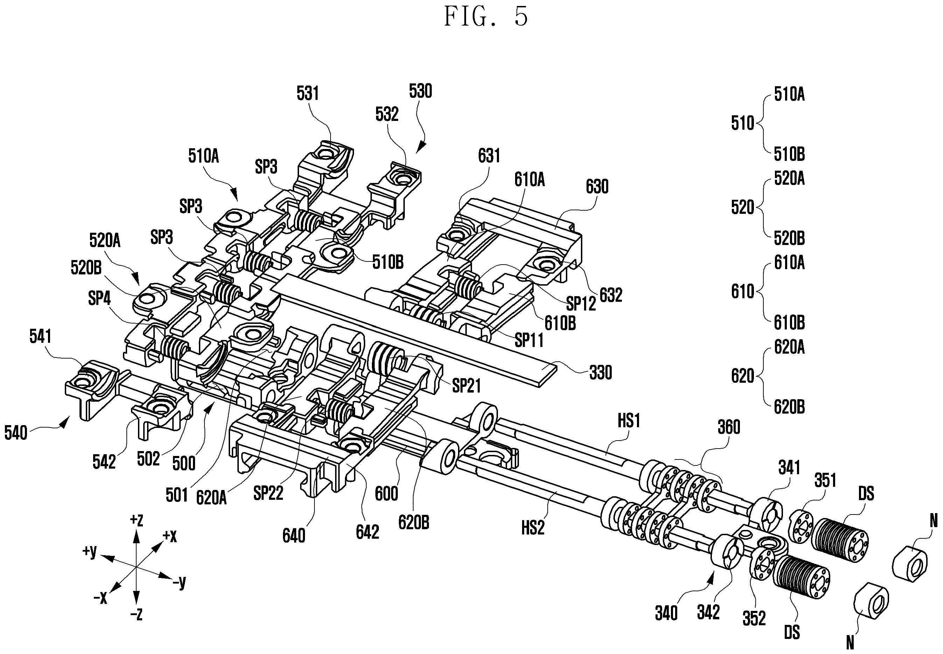

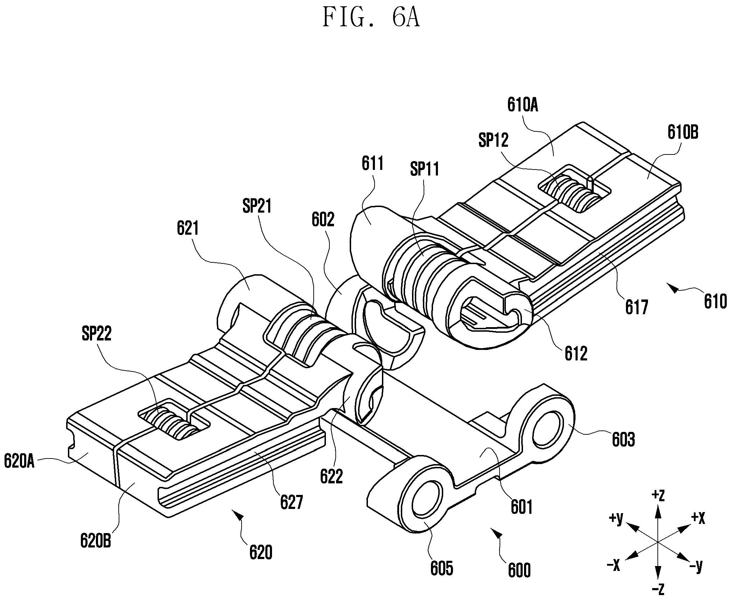

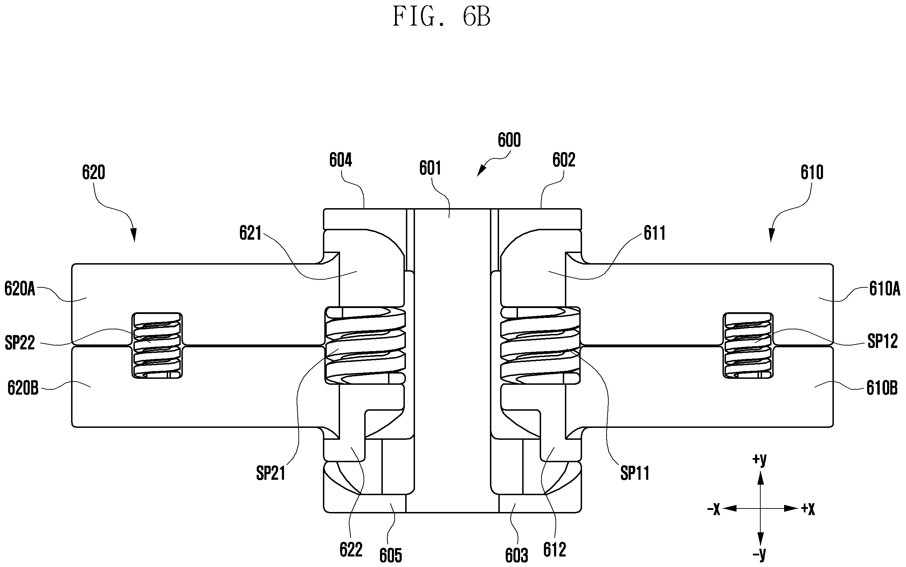

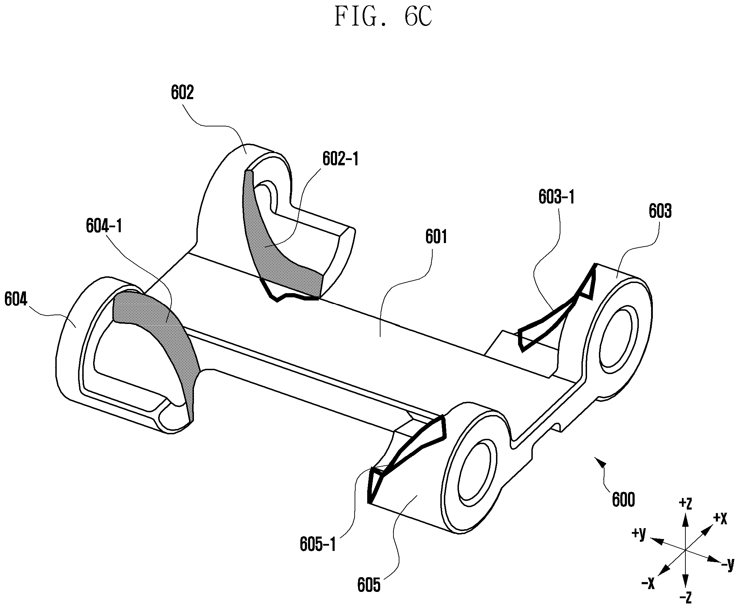

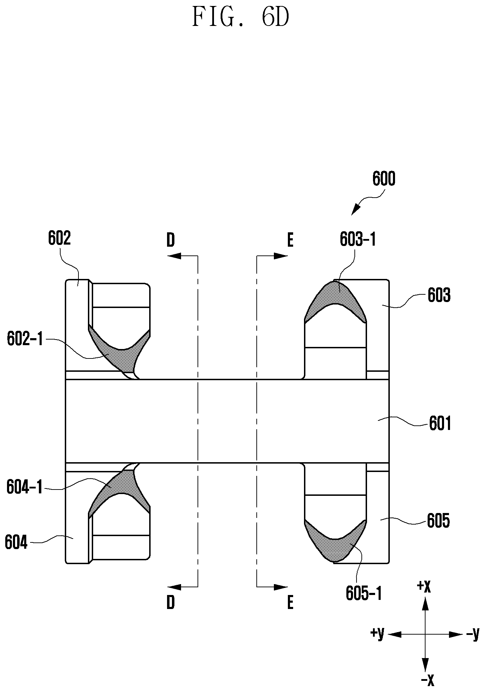

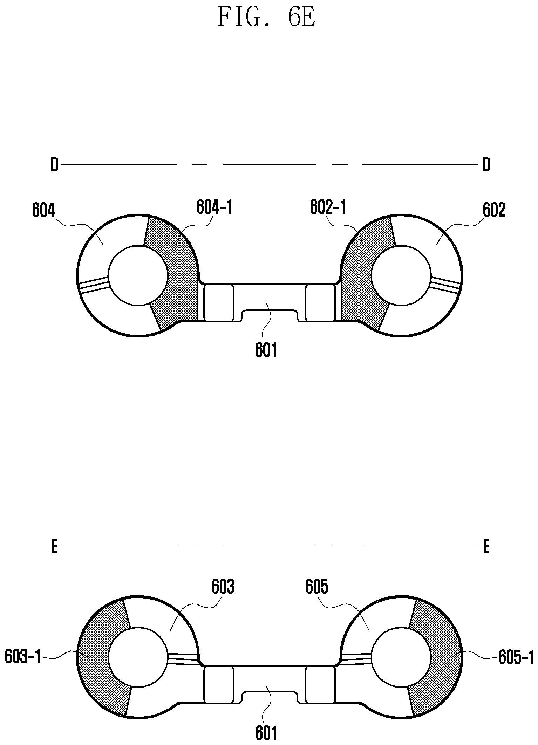

FIG. 4A is a perspective view of a hinge device according to an embodiment of the disclosure in which a first arm link of the hinge device is slidably connected to a first arm module and a second arm link is slidably connected to a second arm module. FIG. 4B is a perspective view of a hinge device according to an embodiment of the disclosure in which a first arm link of the hinge device is rotatably connected to a first arm module and a second arm link is rotatably connected to a second arm module. FIG. 5 is an exploded perspective view of a hinge device according to an embodiment of the disclosure. FIG. 6A is an exploded perspective view of a first arm module, a second arm module, and a slide bracket according to an embodiment of the disclosure. FIG. 6B is a view illustrating the linked relationship among the slide bracket, the first arm module, and the second arm module according to an embodiment of the disclosure illustrated in FIGS. 4A and 4B. FIG. 6C is a perspective view of the slide bracket according to an embodiment of the disclosure. FIG. 6D is a front view of the slide bracket according to an embodiment of the disclosure. FIG. 6E illustrates cross-sectional views of the slide bracket taken along lines D-D and E-E indicated in FIG. 6D.

According to an embodiment, a hinge assembly HA may include one or more hinge devices 320 and 320-1 coupled to a hinge housing 310, a pair of hinge devices 320 and 320-1 coupled to the one or more hinge devices 320 and 320-1, and at least one center bar 330 (e.g., the center bar 330 in FIG. 5) disposed between the pair of hinge plates 311 and 312. In an embodiment, the pair of hinge plates 311 and 312 may include a first hinge plate 311 forming the same plane as the first housing 210 and a second hinge plate 312 forming the same plane as the second housing 220. In an embodiment, when the electronic device 200 is in the unfolded state, the first hinge plate 311, the second hinge plate 312, and the center bar 330 may form the same plane as the first housing 210 and the second housing 220, thereby supporting a flexible display (e.g., the display 230 of FIG. 1A). The components of the hinge assembly HA described above are merely examples, and at least one of the components described above may be omitted as needed, and the hinge assembly HA may be constituted by adding other components.

According to an embodiment, the one or more hinge devices 320 and 320-1 may include first hinge devices 320 disposed at opposite ends of the hinge plates 311 and 312 and the center bar 330, respectively, and a second hinge device 320-1. In an embodiment, a plurality of hinge devices 320 and 320-1 may be provided and disposed between the first housing 210 and the second housing 220. In an embodiment, one hinge device 320 or 320-1 may be arranged or three or more hinge devices 320 and 320-1 may be arranged at a predetermined interval. In an embodiment, the one or more hinge devices 320 and 320-1 may be at least partially fixed to the first housing 210 and the second housing 220. In an embodiment, the one or more hinge devices 320 and 320-1 may be at least partially fixed to the hinge housing 310.

In describing the drawings below, a first hinge device 320 among the one or more hinge devices 320 and 320-1 will be described. The second hinge device 320-1 may have substantially the same configuration as the first hinge device 320, and the description of the second hinge device 320-1 will be replaced with the description of the first hinge device 320.

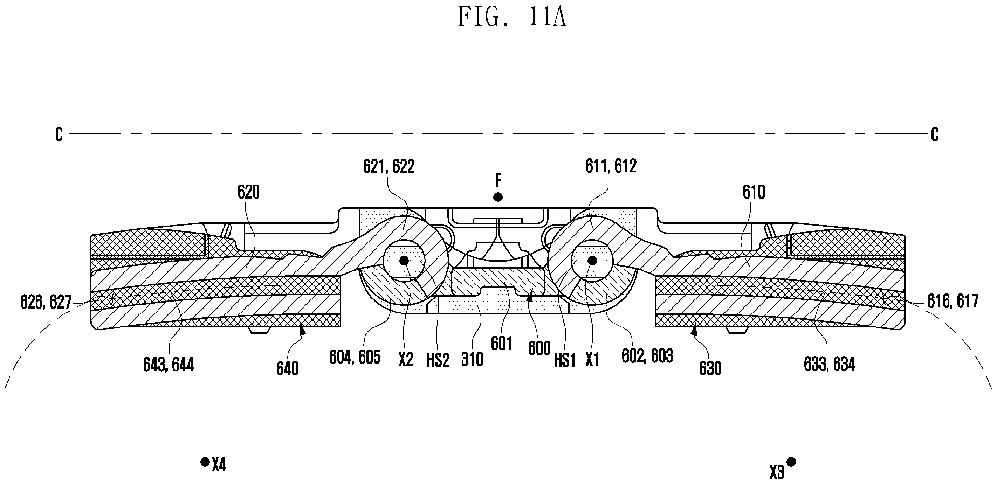

According to an embodiment, as illustrated in FIGS. 4A, 4B, and 5, the hinge device 320 may include a first arm module 610 fitted onto the first shaft HS1 and configured to rotate about the first rotation axis X1, a second arm module 620 fitted onto the second shaft HS2 and configured to rotate about the second rotation axis X2, a slide bracket cam-coupled with the first arm module 610 and the second arm module 620 and configured to move in a direction parallel to the folding axis F in response to the rotations of the first arm module 610 and the second arm module 620, a first arm link 630 movably fastened to the first arm module 610 and fixed to the first housing 210, a second arm link 640 movably fastened to the second arm module 620 and fixed to the second housing 220, a first rotator module 510 at least a portion of which is disposed on the rotator bracket 500 and rotates about the fifth rotation axis X5, a second rotator module 520 at least a portion of which is disposed on the rotator bracket 500 and rotates about the sixth rotation axis X6, a first rotator link 530 fastened to the first rotator module 510 to be rotatable about the seventh rotation axis X7 and fixed to the first housing 210, and a second rotator link 540 fastened to the second rotator module 520 to be rotatable about the eighth rotation axis X8 and fixed to the second housing 220. The components of the hinge device 320 described above are merely examples, and at least one of the components described above may be omitted as needed, and the hinge device 320 may be constituted by adding other components. In an embodiment, as illustrated in FIG. 4B, which will be described later, the first arm link 630 may be coupled to the first arm module 610 to be rotatable about the third rotation axis X3(e.g. The first arm link slides along the rotation radius of a circle centered on the third rotation axis (X3)). In addition, the second arm link 640 may be coupled to the second arm module 620 to be rotatable about the fourth rotation axis X4 (e.g. The second arm link slides along the rotation radius of a circle centered on the fourth rotation axis (X4)). The structures of the first arm module 610-the first arm link 630 and the second arm module 620-the second arm link 640 illustrated in FIG. 4B will be described in detail with reference to FIGS. 11A to 11C, which will be described below. Hereinafter, for convenience of description, as illustrated in FIG. 4A, the description will be given on the premise that the first arm link 630 is connected to enable sliding motion(e.g. straight movable, curved movable) with respect to the the first arm module 610, and the second arm link 640 is connected to enable sliding motion(e.g. straight movable, curved movable) with respect to the second arm module 620.

According to an embodiment, as illustrated in FIGS. 4A, 4B, and 5, the rotator bracket 500 may be combined with the first rotator module 510 and the second rotator module 520. In an embodiment, the first rotator module 510 and the second rotator module 520 are at least partially fastened to the rotator bracket 500 and are rotatable with respect to the rotator bracket 500. In an embodiment, the rotator bracket 500 may include a first coupling portion 501 and a second coupling portion 502. In an embodiment, the first coupling portion 501 and the second coupling portion 502 may be spaced apart in different directions from the center of the rotator bracket 500 corresponding to the folding axis F. For example, the first coupling portion 501 is provided in one direction with respect to the center of the rotator bracket 500, and the second coupling portion 502 is provided in a direction opposite to the one direction with respect to the center of the rotator bracket 500. In an embodiment, the first rotator module 510 has rotation portions (e.g., a first rotation portion 511 and a second rotation portion 512) fastened to the first coupling portion 501 of the rotator bracket 500 and is rotatable about the fifth rotation axis X5. In an embodiment, the second rotator module 520 has rotation portions (e.g., a third rotation portion 521 and a fourth rotation portion 522) fastened to the second coupling portion 502 of the rotator bracket 500 and is rotatable about the sixth rotation axis X6. In an embodiment, the rotator bracket 500 may be made of various materials. For example, the rotator bracket 500 may be made of a metal material or a synthetic resin material.

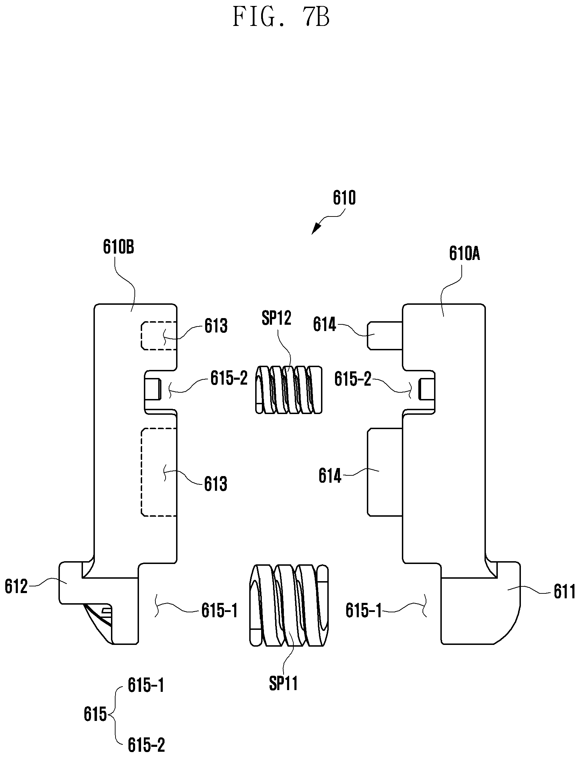

According to an embodiment, as illustrated in FIGS. 4A, 4B, and 5, the hinge device 320 may include a first rotator module 510 connected to the first housing 210 via a first rotator link 530 and a second rotator module 520 connected to the second housing 220 via a second rotator link 540. In an embodiment, the first rotator module 510 may include a first rotator 510A and a second rotator 510B that rotate about the fifth rotation axis X5. In an embodiment, the first rotator 510A and the second rotator 510B may be coupled to rotate together about the fifth rotation axis X5. In an embodiment, referring to FIG. 7B, which will be described later, one of the first rotator 510A and the second rotator 510B may include a third coupling groove 517, and the remaining one of the first rotator 510A and the second rotator 510B may include a third coupling rib 518 inserted into the third coupling groove 517. In an embodiment, at least one elastic member (e.g., a third elastic member SP3) may be disposed between the first rotator 510A and the second rotator 510B. In an embodiment, the third elastic member SP3 may be disposed in a third seating groove 519 which is provided by coupling the first rotator 510A and the second rotator 510B. As will be described later, the elastic member may press the first rotator 510A and the second rotator 510B in opposite directions such that each of the first rotator 510A and the second rotator 510B comes into close contact with the first rotator link 530. In an embodiment, the elastic member may press a first rail fastening portion 513 provided on the first rotation portion 511 of the first rotator 510A, which will be described later, to come into close contact with a (1-1)^{th} rail structure 5011 of the rotator bracket 500. In addition, the elastic member may press a second rail fastening portion 514 provided on the second rotation portion 512 of the second rotator 510B to come into close contact with a (1-2)^{th} rail structure 5012 of the rotator bracket 500.

Likewise, in an embodiment, the second rotator module 520 may include a third rotator 520A and a fourth rotator 520B that rotate about the sixth rotation axis X6. In an embodiment, the third rotator 520A and the fourth rotator 520B may be coupled to be rotate together about the fifth rotation axis X6. In an embodiment, one of the third rotator 520A and the fourth rotator 520B may include a fourth coupling groove, and the remaining one of the third rotator 520A and the fourth rotator 520B may include a fourth coupling rib inserted into the fourth coupling groove. In an embodiment, at least one elastic member (e.g., a fourth elastic member SP4) may be disposed between the third rotator 520A and the fourth rotator 520B. In an embodiment, the elastic member may be disposed in a fourth seating groove (not illustrated) which is provided by coupling the third rotator 520A and the fourth rotator 520B. As will be described later, the elastic member may press the third rotator 520A and the fourth rotator 520B in opposite directions such that each of the third rotator 520A and the fourth rotator 520B comes into close contact with the first rotator link 540. In an embodiment, the elastic member may press a third rail fastening portion 523 provided on the third rotation portion 521 of the third rotator 520A, which will be described later, to come into close contact with a (2-1)^{th} rail structure 5021 of the rotator bracket 500. The elastic member may press a fourth rail fastening portion 524 provided on the fourth rotation portion 522 of the fourth rotator 520B to come into close contact with a (2-2)^{th} rail structure 5022 of the rotator bracket 500.

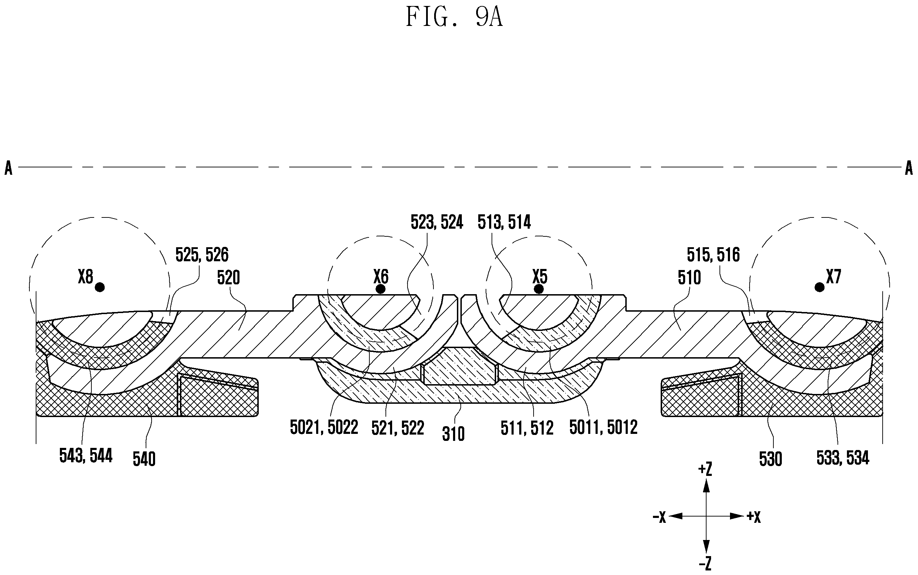

In an embodiment, the first rotator module 510 may include a curved first rotation portion 511 (e.g., the first rotation portion 511 in FIG. 9A) provided in the first rotator 510A and a curved second rotation portion 512 (e.g., the second rotation portion 512 in FIG. 9A) provided in the second rotator 510B. In an embodiment, as the first rotation portion 511 of the first rotator 510A and the second rotation portion 512 of the second rotator 510B are fastened to the first coupling portion 501, the first rotator module 510 may rotate about the fifth rotation axis X5 with respect to the rotator bracket 500. In an embodiment, the first rotation portion 511 of the first rotator 510A may include a curved first rail fastening portion 513 (e.g., the first rail fastening portion 513 in FIG. 9A) fastened to the curved (1-1)^{th} rail structure 5011 (e.g., the (1-1)^{th} rail structure 5011 in FIG. 9A) provided on one surface of the rotator bracket 500. As the first rail fastening portion 513 is guided through the (1-1)^{th} rail structure 5011, the first rotator 510A may rotate about the fifth rotation axis X5 with respect to the rotator bracket 500. The second rotation portion 512 of the second rotator 510B may include a curved second rail fastening portion 514 (e.g., the second rail fastening portion 514 in FIG. 9A) fastened to the curved (1-2)^{th} rail structure 5012 (e.g., the (1-2)^{th} rail structure 5012 in FIG. 9A) provided on the other surface of the rotator bracket 500. As the second rail fastening portion 514 is guided through the (1-2)^{th} rail structure 5012, the second rotator 510B may rotate about the fifth rotation axis X5 with respect to the rotator bracket 500. Likewise, the second rotator module 520 may include a curved third rotation portion 521 (e.g., the third rotation portion 521 in FIG. 9A) provided in the third rotator 520A and a curved fourth rotation portion 522 (e.g., the fourth rotation portion 522 in FIG. 9A) provided in the fourth rotator 520B. In an embodiment, as the third rotation portion 521 of the third rotator 520A and the fourth rotation portion 522 of the fourth rotator 520B are fastened to the second coupling portion 502, the second rotator module 520 may rotate about the sixth rotation axis X6 with respect to the rotator bracket 500. In an embodiment, the third rotation portion 521 of the third rotator 520A may include a curved third rail fastening portion 523 (e.g., the third rail fastening portion 523 in FIG. 9A) fastened to the curved (2-1)^{th} rail structure 5021 (e.g., the (2-1)^{th} rail structure 5021 in FIG. 9A) provided on one surface of the rotator bracket 500. As the third rail fastening portion 523 is guided through the (2-1)^{th} rail structure 5021, the third rotator 520A may rotate about the sixth rotation axis X6 with respect to the rotator bracket 500. The fourth rotation portion 522 of the fourth rotator 520B may include a curved fourth rail fastening portion 524 (e.g., the fourth rail fastening portion 524 in FIG. 9A) fastened to the curved (2-2)^{th} rail structure 5022 (e.g., the (2-2)^{th} rail structure 5022 in FIG. 9A) provided on the other surface of the rotator bracket 500. As the fourth rail fastening portion 524 is guided through the (2-2)^{th} rail structure 5022, the fourth rotator 520B may rotate about the sixth rotation axis X6 with respect to the rotator bracket 500.

According to an embodiment, as illustrated in FIGS. 4A, 4B, and 5, the hinge device 320 may include a first rotator link 530 coupled to the first rotator module 510 to be rotatable about the seventh axis X7 as the first rotator module 510 rotates about the fifth rotation axis X5 with respect to the rotator bracket 500. In an embodiment, the first rotator link 530 may be rotatably coupled to the first rotator module 510 and may be fixed to the first housing 210. In an embodiment, the first rotator 510A of the first rotator module 510 may include a curved first rotator slit 515 provided on one surface thereof. In addition, the second rotator 510B of the first rotator module 510 may include a curved second rotator slit 516 provided on one surface thereof. In an embodiment, the first rotator link 530 may include a (1-1)^{th} rotator fastening portion 531 facing the first rotator 510A and a (1-2)^{th} rotator fastening portion 532 facing the second rotator 510B. In an embodiment, the first rotator 510A and the second rotator 510B may be at least partially located between the (1-1)^{th} rotator fastening portion 531 and the (1-2)^{th} rotator fastening portion 532. For example, the first rotator slit 515 on the first rotator 510A and the second rotator slit 516 on the second rotator 510B may be located between the (1-1)^{th} rotator fastening portion 531 and the (1-2)^{th} rotator fastening portion 532. In an embodiment, the first rotator link 530 may be coupled to be rotatable about the seventh axis X7 with respect to the first rotator module 510 as a curved (1-1)^{th} rotator rib 533 provided on the (1-1)^{th} rotator fastening portion 531 is fastened to the first rotator slit 515 on the first rotator 510A, and a curved (1-2)^{th} rotator rib 534 provided on the (1-2)^{th} rotator fastening portion 532 is fastened to the second rotator slit 516 on the second rotator 510B.

In an embodiment, the hinge device 320 may include a second rotator link 540 coupled to be rotatable about the eighth rotation axis X8 with respect to the second rotator module 520 as the second rotator module 520 rotates about sixth rotation axis X6 with respect to the rotator bracket 500. In an embodiment, the second rotator link 540 may be rotatably coupled to the second rotator module 520 and may be fixed to the second housing 220. In an embodiment, the third rotator 520A of the second rotator module 520 may include a curved third rotator slit 525 provided on one surface thereof. In addition, the fourth rotator 520B of the second rotator module 520 may include a curved fourth rotator slit 526 provided on one surface thereof. In an embodiment, the second rotator link 540 may include a (2-1)^{th} rotator fastening portion 541 facing the third rotator 520A and a (2-2)^{th} rotator fastening portion 542 facing the fourth rotator 520B. In an embodiment, the third rotator 520A and the fourth rotator 520B may be at least partially located between the (2-1)^{th} rotator fastening portion 541 and the (2-2)^{th} rotator fastening portion 542. For example, the third rotator slit 525 on the third rotator 520A and the fourth rotator slit 526 on the fourth rotator 520B may be located between the (2-1)^{th} rotator fastening portion 541 and the (2-2)^{th} rotator fastening portion 542. In an embodiment, the second rotator link 540 may be coupled to be rotatable about the seventh axis X8 with respect to the second rotator module 520 as a curved (2-1)^{th} rotator rib 543 provided on the (2-1)^{th} rotator fastening portion 541 is fastened to the third rotator slit 525 on the third rotator 520A, and a curved (2-2)^{th} rotator rib 544 provided on the (2-2)^{th} rotator fastening portion 542 is fastened to the fourth rotator slit 526 on the fourth rotator 520B.

According to an embodiment, as illustrated in FIGS. 4A, 4B, and 5, the hinge device 320 may include a first arm module 610 connected to the first housing 210 via a first arm link 630 and a second arm module 620 connected to the second housing 220 via a second arm link 640. In an embodiment, the first arm module 610 may include a first arm 610A and a second arm 610B that rotate about the first rotation axis X1. In an embodiment, the first arm 610A and the second arm 610B may be fitted onto the first shaft HS1 to be rotatable about the first shaft HS1. In an embodiment, the rotation axis provided by the first shaft HS1 to the first arm 610A and the second arm 610B may be the same as the first rotation axis X1. In an embodiment, the second arm module 620 may include a third arm 620A and a fourth arm 620B that rotate about the second rotation axis X2. The third arm 620A and the fourth arm 620B may be fitted onto the second shaft HS2 to be rotatable about the second shaft HS2. In an embodiment, the rotation axis provided by the second shaft HS2 to the third arm 620A and the fourth arm 620B may be the same as the second rotation axis X2.

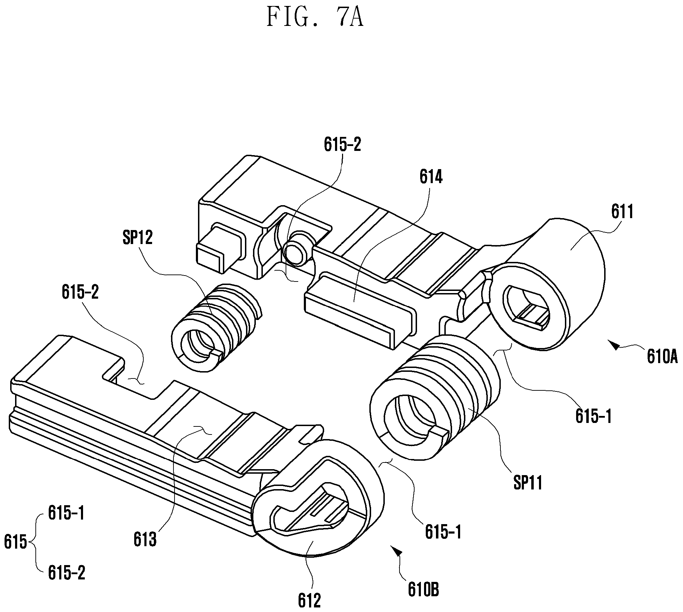

In an embodiment, the first arm 610A and the second arm 610B may be coupled to rotate together about the first rotation axis X1. In an embodiment, referring to FIG. 7A, which will be described later, one of the first arm 610A and the second arm 610B may include a first coupling groove 613, and the remaining one of the first arm 610A and the second arm 610B may include a first coupling rib 614 inserted into the first coupling groove 613. Likewise, the second arm module 620 may include a third arm 620A and a fourth arm 620B that rotate about the second rotation axis X2. In an embodiment, the third arm 620A and the fourth arm 620B may be coupled to rotate together about the second rotation axis X2. In an embodiment, one of the third arm 620A and the fourth arm 620B may include a second coupling groove, and the remaining one of the third arm 620A and the fourth arm 620B may include a second coupling rib inserted into the second coupling groove.

In an embodiment, referring to FIGS. 4A, 4B, and 5, at least one elastic member (e.g., the first elastic member SP11 or SP12) may be disposed between the first arm 610A and the second arm 610B. In an embodiment, the elastic member may be disposed in the (1-1)^{th} seating groove 615-1 provided as the first arm 610A and the second arm 610B are coupled. As will be described later, the elastic member may press the first arm 610A and the second arm 610B in opposite directions such that each of the first arm 610A and the second arm 610B comes into close contact with the first arm link 630. In an embodiment, at least one elastic member (e.g., a second elastic member SP21 or SP22) may be disposed between the third arm 620A and the fourth arm 620B. In an embodiment, the elastic member may be disposed in the (1-2)^{th} seating groove 615-2 provided as the third arm 620A and the fourth arm 620B are coupled. As will be described later, the elastic member may press the third arm 620A and the fourth arm 620B in opposite directions such that each of the third arm 620A and the fourth arm 620B comes into close contact with the second arm link 640.

According to an embodiment, as illustrated in FIGS. 4A, 4B, and 5, the hinge device 320 may include a first arm link 630 coupled to the first arm module 610 to be sliding motion (e.g. linearly movable or curved movable) as the first arm module 610 rotates about the first rotation axis X1 with respect to the slide bracket 600. In an embodiment, the first arm link 630 may be fixed to the first housing 210 and may be sliding motion with respect to the first arm module 610 in response to the rotation of the first arm module 610. In an embodiment, as illustrated in FIG. 4A, when the first arm link 630 slides with respect to the first arm module 610, the first arm 610A may include a first arm slit 616 on one surface thereof. In addition, the second arm 610B may include a linear second arm slit 617 on one surface thereof. According to an embodiment, as illustrated in FIG. 4B, when the first arm link 630 rotates about the third rotation axis X3 with respect to the first arm module 610, the first arm 610A may include a curved first arm slit 616 on one surface thereof. In addition, the second arm 610B may include a curved second arm slit 617 on one surface thereof. In an embodiment, the first arm link 630 may include a (1-1)^{th} arm fastening portion 631 facing the first arm 610A and a (1-2)^{th} arm fastening portion 632 facing the second arm 610B. In an embodiment, the first arm 610A and the second arm 610B may be at least partially located between the (1-1)^{th} arm fastening portion 631 and the (1-2)^{th} arm fastening portion 632. For example, the first arm slit 616 on the first arm 610A and the second arm slit 617 on the second arm 610B may be located between the (1-1)^{th} arm fastening portion 631 and the (1-2)^{th} arm fastening portion 632. In an embodiment, the first arm link 630 may be configured such that the (1-1)^{th} arm rib 633 on the (1-1)^{th} arm fastening portion 631 is fastened to the first arm slit 616 on the first arm 610A, and the (1-2)^{th} arm rib 634 on the (1-2)^{th} arm fastening portion 632 is fastened to the second arm slit 617 on the second arm 610B. Accordingly, the first arm link 630 may be sliding motion in a direction perpendicular to the folding axis F in response to the rotation of the first arm module 610.

According to an embodiment, the hinge device 320 may include a second arm link 640 coupled to the second arm module 620 to be sliding motion (e.g. linearly movable or curved movable) as the second arm module 620 rotates about the second rotation axis X2 with respect to the slide bracket 600. In an embodiment, the second arm link 640 may be fixed to the second housing 220 and may be sliding motion with respect to the second arm module 620 in response to the rotation of the second arm module 620. In an embodiment, as illustrated in FIG. 4A, when the second arm link 640 slides with respect to the second arm module 620, the third arm 620A may include a second arm slit 617 on one surface thereof. In addition, the fourth arm 620B may include a linear fourth arm slit 627 on one surface thereof. According to an embodiment, as illustrated in FIG. 4B, when the second arm link 640 rotates about the fourth rotation axis X4 with respect to the second arm module 620, the third arm 620A may include a curved first arm slit 616 on one surface thereof. In addition, the fourth arm 620B may include a curved second arm slit 617 on one surface thereof. In an embodiment, the second arm link 640 may include a (2-1)^{th} arm fastening portion 641 facing the third arm 620A and a (2-2)^{th} arm fastening portion 642 facing the fourth arm 620B. In an embodiment, the third arm 620A and the fourth arm 620B may be at least partially located between the (2-1)^{th} arm fastening portion 641 and the (2-2)^{th} arm fastening portion 642. For example, the third arm slit 626 on the third arm 620A and the fourth arm slit 627 on the fourth arm 620B may be located between the (2-1)^{th} arm fastening portion 641 and the (2-2)^{th} arm fastening portion 642. In an embodiment, the second arm link 640 may be configured such that the (2-1)^{th} arm rib 643 on the (2-1)^{th} arm fastening portion 641 is fastened to the third arm slit 626 on the third arm 620A, and the (2-2)^{th} arm rib 644 on the (2-2)^{th} arm fastening portion 642 is fastened to the fourth arm slit 627 on the fourth arm 620B. Accordingly, the second arm link 640 may be sliding motion in a direction perpendicular to the folding axis F in response to the rotation of the second arm module 620.

According to an embodiment, as illustrated in FIGS. 4A, 5, and 6A to 6E, the slide bracket 600 may be cam-coupled with the first arm module 610 and the second arm module 620 to link the rotational motions of the first arm module 610 and the second arm module 620 to each other. The slide bracket 600 can be cam-coupled with the first arm module 610 and the second arm module 620 so that the first housing 210 and the second housing 220 can be folded or unfolded by the same angle. The first arm module 610 and the second arm module 620 may rotate together in the unfolding or folding direction of the electronic device 200 and may be linked to rotate in opposite directions. In an embodiment, the first arm module 610 may rotate about the axis of the first shaft HS1 (e.g., the first rotation axis X1) with respect to the slide bracket 600 when the electronic device 200 is folded or unfolded, and the second arm module 620 may rotate about the axis of the second shaft HS2 (e.g., the second rotation axis X2) with respect to the slide bracket 600 in conjunction with the rotational motion of the first arm module 610 via the slide bracket 600.

In an embodiment, the first arm module 610 may include a first cam structure 611 provided on one surface of the first arm 610A and a second cam structure 612 provided on one surface of the second arm 610B. In an embodiment, the first cam structure 611 and the second cam structure 612 may be oriented in opposite directions and may face a portion of the slide bracket 600 (e.g., a first cam portion 602 and a second cam portion 603 of the slide bracket 600). In an embodiment, the second arm module 620 may include a third cam structure 621 provided on one surface of the third arm 620A and a fourth cam structure 622 provided on one surface of the fourth arm 620B. In an embodiment, the third cam structure 621 and the fourth cam structure 622 may be oriented in opposite directions and may face a portion of the slide bracket 600 (e.g., a third cam portion 604 and a fourth cam portion 605 of the slide bracket 600).

According to an embodiment, the slide bracket 600 may include a plurality of cam portions linked with the cam structures provided on the first arm module 610 and the second arm module 620. In an embodiment, referring to FIGS. 6B, 6C, and 6D, the slide bracket 600 may include a body 601, a first cam portion 602 and a second cam portion 603 extending in one direction (e.g., the +X direction with reference to FIG. 6B), and a third cam portion 604 and a fourth cam portion 605 extending from the body 601 in a direction (e.g., the -X direction with reference to FIG. 6B) opposite to the one direction. In an embodiment, the first arm module 610 may be located between the first cam portion 602 and the second cam portion 603 to be cam-coupled with the slide bracket 600. For example, the first cam structure 611 of the first arm 610A may face the first cam portion 602 of the slide bracket 600, and the second cam structure 612 may face the second cam portion 603 of the slide bracket 600. In an embodiment, between the first arm 610A and the second arm 610B, the first elastic members SP11 and SP12 that press the first arm 610A and the second arm 610B in opposite directions (or, in other words, that are arranged to urge the first and second arms apart from, or away from, each other) may be disposed. In an embodiment, the first cam structure 611 of the first arm 610A may be pressed (or urged, or biased) toward the first cam portion 602 via the first elastic members SP11 and SP12, and the second cam structure 612 of the second arm 610B may be pressed (or urged, or biased) toward the second cam portion 603 via the first elastic members SP11 and SP12. Accordingly, the surface pressure acting between the first cam structure 611 and the first cam portion 602 and the surface pressure acting between the second cam structure 612 and the second cam portion 603 may be increased. In addition, the assembly deviation between the first cam structure 611 and the first cam portion 602 and the assembly deviation between the second cam structure 612 and the second cam portion 603 may be decreased. In an embodiment, the second arm module 620 may be located between the third cam portion 604 and the fourth cam portion 605 to be cam-coupled with the slide bracket 600. For example, the third cam structure 621 of the third arm 620A may face the third cam portion 604 of the slide bracket 600, and the fourth cam structure 622 may face the fourth cam portion 605 of the slide bracket 600. In an embodiment, between the third arm 620A and the fourth arm 620B, the second elastic members SP21 and SP22 that press the third arm 620A and the fourth arm 620B in opposite directions (or, in other words, that are arranged to urge the third and fourth arms apart from, or away from, each other) may be disposed. In an embodiment, the third cam structure 621 of the third arm 620A may be pressed (or urged, or biased) toward the third cam portion 604 via the second elastic members SP21 and SP22, and the fourth cam structure 622 of the fourth arm 620B may be pressed (or urged, or biased) toward the fourth cam portion 605 via the second elastic members SP21 and SP22. Accordingly, the surface pressure acting between the third cam structure 621 and the third cam portion 604 and the surface pressure acting between the fourth cam structure 622 and the fourth cam portion 605 may be increased. In addition, the assembly deviation between the third cam structure 621 and the third cam portion 604 and the assembly deviation between the fourth cam structure 622 and the fourth cam portion 605 may be decreased.

In an embodiment, when the electronic device 200 is in the unfolded state, the folded state, and the intermediate state (e.g., the state in which the angle between the first housing 210 and the second housing 220 is 90 degrees), the slide bracket 600 may be in the state in which the first cam portion 602 and the first cam structure 611 of the first arm 610A are in contact with each other, the second cam portion 603 and the second cam structure 612 of the second arm 610B are in contact with each other, the third cam portion 604 and the third cam structure 621 of the third arm 620A are in contact with each other, and the fourth cam portion 605 and the fourth cam structure 622 of the fourth arm 620B are in contact with each other.

In an embodiment, the slide bracket 600 may be sliding motion in a direction (e.g., the Y-axis direction with reference to FIG. 6B) parallel to the folding axis F in response to the rotation of the first arm module 610 and the second arm module 620. For example, referring to FIGS. 4A and 6B, when the electronic device 200 is in the unfolded state, the slide bracket 600 may be in the state in which the first cam portion 602 and the first cam structure 611 of the first arm 610A are engaged with each other, and the third cam portion 604 and the third cam structure 621 of the third arm 620A are engaged with each other. For example, referring to FIG. 6B, when the electronic device 200 is in the unfolded state, the degree to which the first cam portion 602 and the first cam structure 611 are engaged with each other and the third cam portion 604 and the third cam structure 621 are engaged with each other may be greater than the degree to which the second cam portion 603 and the second cam structure 612 are engaged with each other and the fourth cam portion 604 and the fourth cam structure 622 are engaged with each other. In an embodiment, when the electronic device 200 is in the unfolded state, a separation space may be formed between the first cam portion 602 and the first cam structure 611 and between the third cam portion 604 and the third cam structure 621 due to a tolerance. In an embodiment, when the electronic device 200 is switched from the unfolded state to the folded state, the slide bracket 600 may move in a first direction (e.g., the +Y direction with reference to FIG. 6B) as the first cam structure 611 of the first arm 610A rotates while being engaged with the first cam portion 602 and the third cam structure 621 of the third arm 620A rotates while being engaged with the third cam portion 604. When the electronic device 200 is in the intermediate state (e.g., the state in which the angle between the first housing 210 and the second housing 220 is 90 degrees), the slide bracket 600 may be in the state in which the first cam portion 602 and the first cam structure 611 of the first arm 610A are in contact with each other, the second cam portion 603 and the second cam structure 612 of the second arm 610B are in contact with each other, the third cam portion 604 and the third cam structure 621 of the third arm 620A are in contact with each other, and the fourth cam portion 605 and the fourth cam structure 622 of the fourth arm 620B are in contact with each other. Thereafter, when the electronic device 200 is switched into the folded state, the slide bracket 600 may be in the state in which the second cam portion 603 and the second cam structure 612 of the second arm 610B are engaged with each other, and the fourth cam portion 605 and the fourth cam structure 622 of the fourth arm 620B are engaged with each other. For example, when the electronic device 200 is in the folded state, the degree to which the second cam portion 603 and the second cam structure 612 are engaged with each other and the fourth cam portion 604 and the fourth cam structure 622 are engaged with each other may be greater than the degree to which the first cam portion 602 and the first cam structure 611 are engaged with each other and the third cam portion 604 and the third cam structure 621 are engaged with each other. In an embodiment, when the electronic device 200 is in the folded state, a separation space may be formed between the second cam portion 603 and the second cam structure 612 and between the fourth cam portion 604 and the fourth cam structure 622 due to a tolerance. In an embodiment, when the electronic device 200 is switched from the folded state to the unfolded state, the slide bracket 600 may move in a second direction (e.g., the -Y direction with reference to FIG. 6B) as the second cam structure 612 of the second arm 610B rotates while being engaged with the second cam portion 603 and the fourth cam structure 622 of the fourth arm 620B rotates while being engaged with the fourth cam portion 605. Thereafter, when the electronic device 200 is switched into the unfolded state, the slide bracket 600 may be in the state in which the first cam portion 602 and the first cam structure 611 of the first arm 610A are engaged with each other, and the third cam portion 604 and the third cam structure 621 of the third arm 620A are engaged with each other.

The above-described structure is merely an example, and when the electronic device is in the unfolded state, the slide bracket 600 may be in the state in which the second cam portion 603 and the second cam structure 612 of the second arm 610B are engaged with each other, and the fourth cam portion 605 and the fourth cam structure 622 of the fourth arm 620B are engaged with each other. In addition, when the electronic device is in the folded state, the slide bracket 600 may be in the state in which the first cam portion 602 and the first cam structure 611 of the first arm 610A are engaged with each other, and the third cam portion 604 and the third cam structure 621 of the third arm 620A are engaged with each other. The following description will be given on the premise that, when the electronic device 200 is in the unfolded state, the degree (e.g. the size and/or position of the mutual contact area) to which the first cam portion 602 and the first cam structure 611 are engaged with each other and the third cam portion 604 and the third cam structure 621 are engaged with each other is greater than the degree to which the second cam portion 603 and the second cam structure 612 are engaged with each other and the fourth cam portion 604 and the fourth cam structure 622 are engaged with each other. For example, the size of the mutual contact area between the first cam structure 611, the first cam portion 602, and/or the third cam portion 621 and the third cam portion 604 may be larger than the size of the mutual contact area between the second cam portion 603, the second cam structure 612, and/or the fourth cam portion 604 and the fourth cam structure 622. The degree of engagement between a respective cam portion and a respective cam structure can, for example, be expressed in terms of the size and/or position of the contact area between their respective cam (i.e. inclined) surfaces. The following description will be given on the premise that, when the electronic device 200 is in the folded state, the degree to which the second cam portion 603 and the second cam structure 612 are engaged with each other and the fourth cam portion 604 and the fourth cam structure 622 are engaged with each other is greater than the degree to which the first cam portion 602 and the first cam structure 611 are engaged with each other and the third cam portion 604 and the third cam structure 621 are engaged with each other.

According to an embodiment, the slide bracket 600 may be made in various ways. In an embodiment, the slide bracket 600 may be made in an integrated shape in consideration of production cost, product cost, and product miniaturization. In this case, a mold that molds a first inclined surface 602-1 of the first cam portion 602, a second inclined surface 603-1 of the second cam portion 603, a third inclined surface 604-1 of the third cam portion 604, and a fourth inclined surface 605-1 of the fourth cam portion 605 may be inserted in a direction perpendicular to the slide bracket 600. Accordingly, when the slide bracket 600 is viewed in a vertical direction (e.g., the -Z direction in FIG. 4A), as illustrated in FIG. 6D, the first inclined surface 602-1, the second inclined surface 603-1, the third inclined surface 604-1, and the fourth inclined surface 605-1 may be oriented in the same direction (e.g., the +Z direction with reference to FIG. 4A). Therefore, when the slide bracket 600 is viewed in a vertical direction (e.g., the -Z direction in FIG. 4A), all of the first inclined surface 602-1, the second inclined surface 603-1, and the third inclined surface 604-1, and the fourth inclined surface 605-1 can be seen.

According to an embodiment, as illustrated in FIGS. 6C, 6D, and 6E, the cam portions 602, 603, 604, and 605 of the slide bracket 600 may be molded in consideration of cam-assembly with the first arm module 610 and the second arm module 620. In an embodiment, the first cam portion 602 and the third cam portion 604 of the slide bracket 600 may be molded in shapes that can be engaged with each other such that the first arm 610A of the first arm module 610 and the third arm 620A of the second arm module 620 can be linked with each other. For example, the first inclined surface 602-1 of the first cam portion 602 and the third inclined surface 604-1 of the third cam portion 604 may be molded to be symmetrical to each other with respect to the folding axis F and to have the same shape. Since the first cam structure 611 of the first arm 610A and the third cam structure 621 of the third arm 620A are molded in shapes that can be engaged with the first cam portion 602 and the third cam portion 604, respectively, the first arm 610A and the first cam portion 602 may be linked with the third arm 620A and the second cam portion 603. In an embodiment, the second cam portion 603 and the fourth cam portion 605 of the slide bracket 600 may be molded in shapes that can be engaged with each other such that the second arm 610B of the first arm module 610 and the fourth arm 620B of the second arm module 620 can be linked with each other. For example, the second inclined surface 603-1 of the second cam portion 603 and the fourth inclined surface 605-1 of the fourth cam portion 605 may be molded to be symmetrical to each other with respect to the folding axis F and to have the same shape. Since the second cam structure 612 of the second arm 610B and the fourth cam structure 622 of the fourth arm 620A are molded in shapes that can be engaged with the second cam portion 603 and the fourth cam portion 605, respectively, the second arm 610B and the second cam portion 603 may be linked with the fourth arm 620B and the fourth cam portion 605.

In an embodiment, the slide bracket 600 may be produced by separating it into at least two sections in consideration of convenience of the production process. In an embodiment, the slide bracket 600 may include a first slide bracket 600 including the first cam portion 602 and the third cam portion 604, and a second slide bracket 600 including the second cam portion 603 and the fourth cam portion 605. The first cam portion 602 and the third cam portion 604 of the first slide bracket 600 may be molded through various injection molding processes. For example, the first inclined surface 602-1 of the first cam portion 602 and the third inclined surface 604-1 of the third cam portion 604 may be molded by using a mold inserted into the first slide bracket 600 in at least one axis among three axes (the X, Y, and Z axes). In addition, the second inclined surface 603-1 of the second cam portion 603 and the fourth inclined surface 605-1 of the fourth cam portion 605 of the second slide bracket 600 may be molded by using a mold inserted into the second slide bracket 600 in at least one axis among three axes (the X, Y, and Z axes). Accordingly, the first inclined surface 602-1, the second inclined surface 603-1, the third inclined surface 604-1, and the fourth inclined surface 605-1 may be molded in various shapes depending on linking conditions with the first arm module 610 and the second arm module 620. After the injection molding process is completed, the first slide bracket 600 and the second slide bracket 600 are coupled via fixing members (bolts and nuts, screws (S), adhesive, and welding), thereby allowing the rotational motions of the first arm module 610 and the second arm module 620 to be linked with each other.

In the foregoing, in describing the production process of the slide bracket 600, the injection molding process has been described as an example. However, the disclosure may not be limited to the injection molding process, and the slide bracket 600 may be formed through various production processes that can be performed by a person ordinarily skilled in the art.

In an embodiment, referring to FIGS. 4A, 4B, and 6A, the hinge device 320 may include one or more first elastic members SP11 and SP12 disposed between the first arm 610A and the second arm 610B to press the first arm 610A and the second arm 610B in opposite directions, and one or more second elastic members SP21 and SP22 disposed between the third arm 620A and the fourth arm 620B to press the third arm 620A and the fourth arm 620B in opposite directions. In an embodiment, the first elastic members SP11 and SP12 may include a (1-1)^{th} elastic member SP11 disposed between the first cam structure 611 of the first arm 610A and the second cam structure 612 of the second arm 610B to press the first cam structure 611 and the second cam structure 612 in opposite direction, and a (1-2)^{th} elastic member SP12 disposed between the first arm 610A and the second arm 610B to press the first arm 610A and the second arm 610B toward the first arm link 630. In an embodiment, the second elastic members SP21 and SP22 may include a (2-1)^{th} elastic member SP21 disposed between the third cam structure 621 of the third arm 620A and the fourth cam structure 622 of the fourth arm 620B to press the third cam structure 621 and the fourth cam structure 622 in opposite direction, and a (2-2)^{th} elastic member SP22 disposed between the third arm 620A and the fourth arm 620B to press the third arm 620A and the fourth arm 620B toward the second arm link 640.

The following description is given on the premise that at least two first elastic members SP11 and SP12 are disposed between the first arm 610A and the second arm 610B, but the disclosure may not be limited thereto. In an embodiment, in the first elastic members SP11 and SP12, at least one of the (1-1)^{th} elastic member SP11 and the (1-2)^{th} elastic member SP12 may be omitted, or at least one elastic member may be further included. Likewise, the following description is given on the premise that at least two second elastic members SP21 and SP22 are disposed between the third arm 620A and the fourth arm 620B, but the disclosure may not be limited thereto. In an embodiment, in the second elastic members SP21 and SP22, at least one of the (2-1)^{th} elastic member SP21 and the (2-2)^{th} elastic member SP22 may be omitted, or at least one elastic member may be further included.

In an embodiment, the (1-1)^{th} elastic member SP11 may be disposed between the first cam structure 611 of the first arm 610A and the second cam structure 611 of the second arm 610B in the state of being fitted onto the first shaft HS1. In addition, the (2-1)^{th} elastic member SP21 may be disposed between the third cam structure 621 of the third arm 620A and the fourth cam structure 622 of the fourth arm 620B in the state of being fitted onto the second shaft HS2.

In an embodiment, the first arm module 610 may be pressed via the first elastic members SP11 and SP12 such that the first cam structure 611 of the first arm 610A is directed to the first cam portion 602 of the slide bracket 600 and the second cam structure 612 of the second arm 610B is directed to the second cam portion 603 of the slide bracket 600. In an embodiment, the first cam structure 611 of the first arm 610A and the first cam portion 602 of the slide bracket 600 may be in close contact via the first elastic members SP11 and SP12. For example, when the first cam structure 611 and the first cam portion 602 come into contact with each other depending on the folding operation of the electronic device 200 (e.g., switching from the folded state to the unfolded state or from the unfolded state to the folded state), the first cam structure 611 of the first arm 610A may be pressed via the first elastic members SP11 and SP12 so that the contact force with the first cam portion 602 can be increased. In an embodiment, the second cam structure 612 of the second arm 610B and the second cam portion 603 of the slide bracket 600 may be in close contact via the first elastic members SP11 and SP12. For example, when the second cam structure 612 and the second cam portion 603 come into contact with each other depending on the folding operation of the electronic device 200, the contact force of the second cam structure 612 of the second arm 610B with the second cam portion 603 of the slide bracket 600 can be increased via the first elastic members SP11 and SP12.

Likewise, the second arm module 620 may be pressed via the second elastic members SP21 and SP22 such that the third cam structure 621 of the third arm 620A is directed to the third cam portion 604 of the slide bracket 600 and the fourth cam structure 622 of the fourth arm 620B is directed to the fourth cam portion 605 of the slide bracket 600. In an embodiment, the third cam structure 621 of the third arm 620A and the third cam portion 604 of the slide bracket 600 may be in close contact via the second elastic members SP21 and SP22. For example, when the third cam structure 621 and the third cam portion 604 come into contact with each other depending on the folding operation of the electronic device 200, the contact force of the third cam structure 621 of the third arm 620A with the third cam portion 604 can be increased via the second elastic members SP21 and SP22. In addition, the fourth cam structure 622 of the fourth arm 620B and the fourth cam portion 605 of the slide bracket 600 may be in close contact via the second elastic members SP21 and SP22. For example, depending on the folding operation of the electronic device 200, the contact force of the fourth cam structure 622 of the fourth arm 620B with the fourth cam portion 605 can be increased via the second elastic members SP21 and SP22.

In an embodiment, referring to FIGS. 4A and 6B, when the electronic device 200 is in the unfolded state, the slide bracket 600 may be in the state in which the first cam portion 602 and the first cam structure 611 of the first arm 610A are engaged with each other, and the third cam portion 604 and the third cam structure 621 of the third arm 620A are engaged with each other. In this case, since the first cam structure 611 is pressed toward the first cam portion 602 via the first elastic members SP11 and SP12, the assembly deviation (e.g. tolerance, gap) between the first cam structure 611 and the first cam portion 602 may be decreased and the contact force therebetween may be increased. In addition, since the third cam structure 621 is pressed toward the third cam portion 604 via the second elastic members SP21 and SP22, the assembly deviation between the third cam structure 621 and the third cam portion 604 may be decreased and the contact force therebetween may be increased. In an embodiment, when the electronic device 200 is in the folded state, the slide bracket 600 may be in the state in which the second cam portion 603 and the second cam structure 612 of the second arm 610B are engaged with each other, and the fourth cam portion 605 and the fourth cam structure 622 of the fourth arm 620B are engaged with each other. In this case, since the second cam structure 612 is pressed toward the second cam portion 603 via the first elastic members SP11 and SP12, the assembly deviation between the second cam structure 612 and the second cam portion 603 may be decreased and the contact force therebetween may be increased. In addition, since the fourth cam structure 622 is pressed toward the fourth cam portion 605 via the second elastic members SP21 and SP22, the assembly deviation between the fourth cam structure 622 and the fourth cam portion 605 may be decreased and the contact force therebetween may be increased. According to an embodiment of the disclosure, depending on the folding operation of the electronic device 200, the first arm module 610 and the second arm module 620 may rotate in conjunction with the slide bracket 600. Depending on the folding state (e.g., the unfolded state, the intermediate state, or the folded state) of the electronic device 200, the first cam structure 611 and the second cam structure 612 of the first arm module 610 and the third cam structure 621 and the fourth cam structure 622 of the second arm module 620 may be pressed toward the cam portion 602, the second cam portion 603, the third cam portion 604, and/or the fourth cam portion 605 via the first elastic members SP11 and SP12 and the second elastic members SP21 and SP22, respectively. Accordingly, the contact forces between the first cam structure 611 and the first cam portion 602, between the second cam structure 612 and the second cam portion 603, between the third cam structure 621 and the third cam portion 604, and /or between fourth cam structure 622 and the fourth cam portion may be increased. Accordingly, the assembly deviation of the first arm module 610 and the second arm module 620 with respect to the slide bracket 600 may be decreased, and as a result, the deviation in rotational linking between the first arm module 610 and the second arm module 620 via the slide bracket 600 may be decreased. Accordingly, the feeling of operation of the hinge device 320 can be improved.

According to an embodiment, as illustrated in FIGS. 4A, 5, and 6B, the first elastic members SP11 and SP12 may decrease the assembly deviation between the first arm module 610 and the first arm link 630. In an embodiment, the first arm 610A and the second arm 610B of the first arm module 610 may be in close contact with the first arm link 630 via the first elastic members SP11 and SP12. In an embodiment, the first elastic members SP11 and SP12 may press the first arm 610A toward the (1-1)^{th} arm fastening portion 631 of the first arm link 630 and may press the second arm 610B toward the (1-2)^{th} arm fastening portion 632 of the first arm link 630. In this case, the first arm slit 616 on the first arm 610A may be pressed toward the (1-1)^{th} arm rib 633 on the (1-1)^{th} arm fastening portion 631. In addition, the second arm slit 617 on the second arm 610B may be pressed toward the (1-2)^{th} arm rib 634 on the (1-2)^{th} arm fastening portion 632. Likewise, in an embodiment, the second elastic members SP21 and SP22 may decrease the assembly deviation between the second arm module 620 and the second arm link 640. In an embodiment, the third arm 620A and the fourth arm 620B of the second arm module 620 may be in close contact with the second arm link 640 via the second elastic members SP21 and SP22. In an embodiment, the second elastic members SP21 and SP22 may press the third arm 620A toward the (2-1)^{th} arm fastening portion 641 of the second arm link 640 and may press the fourth arm 620B toward the (2-2)^{th} arm fastening portion 642 of the second arm link 640. In this case, the third arm slit 626 on the third arm 620A may be pressed toward the (2-1)^{th} arm rib 643 on the (2-1)^{th} arm fastening portion 641. In addition, the fourth arm slit 627 on the fourth arm 620B may be pressed toward the (2-2)^{th} arm rib 644 on the (2-2)^{th} arm fastening portion 642. Therefore, since the assembly deviation between the first arm module 610 and the first arm link 630 is decreased via the first elastic members SP11 and SP12, and the assembly deviation between the second arm module 620 and the second arm link 640 is decreased by the second elastic members SP21 and SP22, the feeling of operation of the hinge device 320 can be improved.

In an embodiment, referring to FIGS. 4A, 4B, and 6B, the hinge device 320 may include a third elastic members SP3 disposed between the first rotator 510A and the second rotator 510B to press the first rotator 510A and the second rotator 510B in opposite directions, and a fourth elastic member SP4 disposed between the third rotator 520A and the fourth rotator 520B to press the third rotator 520A and the fourth rotator 520B in opposite directions.

The following description is given on the premise that the third elastic member SP3 is disposed between the first rotator 510A and the second rotator 510B, but the disclosure may not be limited thereto. In an embodiment, only one third elastic member SP3 may be disposed between the first rotator 510A and the second rotator 510B. Likewise, the following description is given on the premise that the fourth elastic member SP4 is disposed between the third rotator 520A and the fourth rotator 520B, but the disclosure may not be limited thereto. In an embodiment, only one fourth elastic member SP4 may be disposed between the third rotator 520A and the fourth rotator 520B.

In an embodiment, the third elastic member SP3 may decrease the assembly deviation between the first rotator module 510 and the first rotator link 530. In an embodiment, the first rotator 510A and the second rotator 510B of the first rotator module 510 may be in close contact with the first rotator link 530 via the third elastic member SP3. In an embodiment, the third elastic member SP3 may press the first rotator 510A toward the (1-1)^{th} rotator fastening portion 531 of the first rotator link 530 and may press the second rotator 510B toward the (1-2)^{th} rotator fastening portion 532 of the first rotator link 530. In this case, the first rotator slit 515 on the first rotator 510A may be pressed toward the (1-1)^{th} rotator rib 533 on the (1-1)^{th} rotator fastening portion 531. In addition, the second rotator slit 516 on the second rotator 510B may be pressed toward the (1-2)^{th} rotator rib 534 on the (1-2)^{th} rotator fastening portion 532. Likewise, in an embodiment, the fourth elastic member SP4 may decrease the assembly deviation between the second rotator module 520 and the second rotator link 540. In an embodiment, the third rotator 520A and the fourth rotator 520B of the second rotator module 520 may be in close contact with the second rotator link 540 via the fourth elastic member SP4. In an embodiment, the fourth elastic member SP4 may press the third rotator 520A toward the (2-1)^{th} rotator fastening portion 541 of the second rotator link 540 and may press the fourth rotator 520B toward the (2-2)^{th} rotator fastening portion 542 of the second rotator link 540. In this case, the third rotator slit 525 on the third rotator 520A may be pressed toward the (2-1)^{th} rotator rib 543 on the (2-1)^{th} rotator fastening portion 541. In addition, the fourth rotator slit 526 on the fourth rotator 520B may be pressed toward the (2-2)^{th} rotator rib 544 on the (2-2)^{th} rotator fastening portion 542. Therefore, since the assembly deviation between the first rotator module 510 and the first rotator link 530 is decreased via the third elastic member SP3, and the assembly deviation between the second rotator module 520 and the second rotator link 540 is decreased by the fourth elastic member SP4, the feeling of operation of the hinge device 320 can be improved.

In an embodiment, the third elastic member SP3 may decrease the assembly deviation between the first rotation portion 511 and the second rotation portion 512 of the first rotator module 510 and the first coupling portion 501 of the rotator bracket 500. In an embodiment, the first rotator 510A may be inserted into the first coupling portion 501 such that the first rail fastening portion 513 provided on the first rotation portion 511 is fastened to the (1-1)^{th} rail structure 5011 provided on one surface of the rotator bracket 500. The second rotator 510B may be inserted into the first coupling portion 501 such that the second rail fastening portion 514 provided on the second rotation portion 512 is fastened to the (1-2)^{th} rail structure 5012 provided on one surface of the rotator bracket 500. In an embodiment, the third elastic member SP3 may press the first rotator 510A toward the (1-1)^{th} rail structure 5011 of the rotator bracket 500 and may press the second rotator 510B toward the (1-2)^{th} rail structure 5012 of the rotator bracket 500. In this case, the assembly deviation between the first rail fastening portion 513 of the first rotator 510A and the (1-1)^{th} rail structure 5011 may be decreased. In addition, the assembly deviation between the second rail fastening portion 514 of the second rotator 510B and the (1-2)^{th} rail structure 5012 may be decreased. Likewise, the fourth elastic member SP4 may decrease the assembly deviation between the third rotation portion 521 and the fourth rotation portion 522 of the second rotator module 520 and the second coupling portion 502 of the rotator bracket 500. In an embodiment, the third rotator 520A may be inserted into the second coupling portion 502 such that the third rail fastening portion 523 provided on the third rotation portion 521 is fastened to the (2-1)^{th} rail structure 5021 provided on one surface of the rotator bracket 500. The fourth rotator 520B may be inserted into the second coupling portion 502 such that the fourth rail fastening portion 524 provided on the fourth rotation portion 522 is fastened to the (2-2)^{th} rail structure 5022 provided on one surface of the rotator bracket 500. In an embodiment, the fourth elastic member SP4 may press the third rotator 520A toward the (2-1)^{th} rail structure 5021 of the rotator bracket 500 and may press the fourth rotator 520B toward the (2-2)^{th} rail structure 5022 of the rotator bracket 500. In this case, the assembly deviation between the third rail fastening portion 523 of the third rotator 520A and the (2-1)^{th} rail structure 5021 may be decreased. In addition, the assembly deviation between the fourth rail fastening portion 524 of the fourth rotator 520B and the (2-2)^{th} rail structure 5022 may be decreased. Therefore, since the assembly deviation between the first rotator module 510 and the first coupling portion 501 is decreased via the third elastic member SP3, and the assembly deviation between the second rotator module 520 and the second coupling portion 502 is decreased by the fourth elastic member SP4, the feeling of operation of the hinge device 320 can be improved.

In an embodiment, a description has been given on the premise that the first elastic members SP11 and SP12, the second elastic members SP21 and SP22, the third elastic member SP3, and the fourth elastic member SP4 are springs, but the disclosure may not be limited thereto. The first elastic members SP11 and SP12, the second elastic members SP21 and SP22, the third elastic member SP3, and the fourth elastic member SP4 may be made of an elastic material such as rubber, urethane, or epoxy, rather than being configured with springs.

In an embodiment, the first elastic members SP11 and SP12, the second elastic members SP21 and SP22, the third elastic member SP3, and/or the fourth elastic member SP4 may be arranged to be symmetrical to each other with respect to the folding axis F.

In an embodiment, the first elastic members SP11 and SP12, the second elastic members SP21 and SP22, the third elastic member SP3, and/or the fourth elastic member SP4 may be made in various sizes. In an embodiment, referring to FIG. 6B and FIG. 7A, which will be described later, the (1-1)^{th} elastic member SP11 may be configured to be thicker than the (1-2)^{th} elastic member SP12. In an embodiment, the (2-1)^{th} elastic member SP21 may be configured to be thicker than the (2-2)^{th} elastic member SP22. In an embodiment, a plurality of third elastic members SP3 may be made in different sizes depending on the required elastic force. In an embodiment, a plurality of fourth elastic members SP4 may be made in different sizes depending on the required elastic force.

According to an embodiment, as illustrated in FIGS. 4A, 4B, and 5, the first shaft HS1 may be inserted into the first arm module 610 such that the first arm module 610 rotates about the first rotation axis X1. The second shaft HS2 may be inserted into the second arm module 620 such that the second arm module 620 rotates about the second rotation axis X2.

According to an embodiment, as illustrated in FIGS. 4A, 4B, and 5, a rotator bracket 500, a slide bracket 600, a torque bracket 360, a cam body 340, cam structures 351 and 352, and springs DS may be sequentially fitted onto the first shaft HS1 and the second shaft HS2. In an embodiment, the cam body 340, the cam structures 351 and 352, and the springs DS may generate a stop force of the hinge device 320 required to maintain the unfolded state or folded state or a free stop force (e.g., the first housing). The free stop force required to maintain the intermediate state (e.g., the state in which the angle between the first housing 210 and the second housing 220 is 90 degrees). In an embodiment, the torque bracket 360 may support the cam body 340 to induce high torque between the cam body 340 and the cam structures 351 and 352.

According to an embodiment, the hinge device 320 may include a cam assembly. In an embodiment, referring to FIGS. 4A, 4B, and 5, the cam assembly may include a cam body 340, a first cam structure 351, a second cam structure 352, and a plurality of springs DS (e.g., a disk spring and/or a coil spring) in a manner of being sequentially fitted onto the first shaft HS1 and the second shaft HS2. In an embodiment, the first cam structure 351 may be fitted onto the first shaft HS1 to be engaged with the first cam 341 provided on one surface of the cam body 340. The second cam structure 352 may be fitted onto the second shaft HS2 to be engaged with the second cam 342 provided on one surface of the cam body 340. In an embodiment, one of the plurality of springs DS may be fitted onto the first shaft HS1 and supported by a fixing member N (e.g., a nut) fixed to the terminal end of the first shaft HS1 to press the first cam structure 351 toward the first cam 341 of the cam body 340. Another one of the plurality of springs DS may be fitted onto the second shaft HS2 and supported by a fixing member N (e.g., a nut) fixed to the terminal end of the second shaft HS2 to press the second cam structure 352 toward the second cam 342 of the cam body 340.

According to an embodiment, a stop operation (detent) and a free stop operation may be necessary to increase usability of the electronic device 200. The stop operation may be an operation of maintaining the electronic device 200 in the fully folded state or in the fully unfolded state. The free stop operation may be an operation of maintaining the state of the electronic device 200 when an external force equal to or greater than a certain level does not act on the electronic device 200 during the process of switching from the folded state to the unfolded state or the process of switching from the unfolded state to the folded state. The stop operation and the free stop operation may be implemented by causing the first cam 341 and the first cam structure 351 of the cam body 340 and the second cam 342 and the second cam structure 352 of the cam body 340 to be engaged with each other. In an embodiment, the first arm module 610 may rotate about the axis of the first shaft HS1 (e.g., the first rotation axis X1) with respect to the slide bracket 600 when the electronic device 200 is folded or unfolded, and the second arm module 620 may rotate about the axis of the second shaft HS2 (e.g., the second rotation axis X2) with respect to the slide bracket 600 in conjunction with the rotational motion of the first arm module 610 via the slide bracket 600. In an embodiment, the slide bracket 600 may linearly move in a direction (e.g., the Y-axis direction with reference to FIG. 4A) parallel to the folding axis F in response to the rotation of the first arm module 610 and the second arm module 620. For example, when the electronic device 200 is in the unfolded state, the slide bracket 600 may be in the state in which the first cam portion 602 and the first cam structure 611 of the first arm 610A are engaged with each other, and the third cam portion 604 and the third cam structure 621 of the third arm 620A are engaged with each other. When the electronic device 200 is switched from the unfolded state to the folded state, as the first cam portion 602 and the first cam structure 611 rotate while being engaged with the third cam portion 604 and the third cam structure 621, the slide bracket may move in a first direction (e.g., the +Y direction with reference to FIG. 4A). The cam body 340, the first cam structure 351, and the cam body 340 arranged to be movable only in the axial direction (e.g., the Y-axis direction with reference to FIG. 4A) on the first shaft HS1 and the second shaft HS2, the first cam structure 351 and the second cam structure 352 may move in the first direction while being pressed by the springs DS. Thereafter, when the electronic device 200 is switched into the folded state, the slide bracket 600 may be in the state in which the second cam portion 603 and the second cam structure 612 of the second arm 610B are engaged with each other, and the fourth cam portion 605 and the fourth cam structure 622 of the fourth arm 620B are engaged with each other. When the electronic device 200 is switched from the folded state to the folded state, as the second cam portion 603 and the second cam structure 612 rotate while being engaged with the fourth cam portion 605 and the fourth cam structure 622, the slide bracket may move in a second direction (e.g., the -Y direction with reference to FIG. 4A). The cam body 340, the first cam structure 351, and the cam body 340 arranged to be movable only in the axial direction (e.g., the Y-axis direction with reference to FIG. 4A) on the first shaft HS1 and the second shaft HS2 may move in the second direction and may be pressed more than when the electronic device 200 is in the folded state. Accordingly, the first housing 210 and the second housing 220 may be provided with a stop force for maintaining the folded state or the unfolded state or a force capable of maintaining a state at a certain intermediate angle via the cam coupling between the cam body 340 and the cam structures (e.g., the first cam structure 351 and the second cam structure 352).

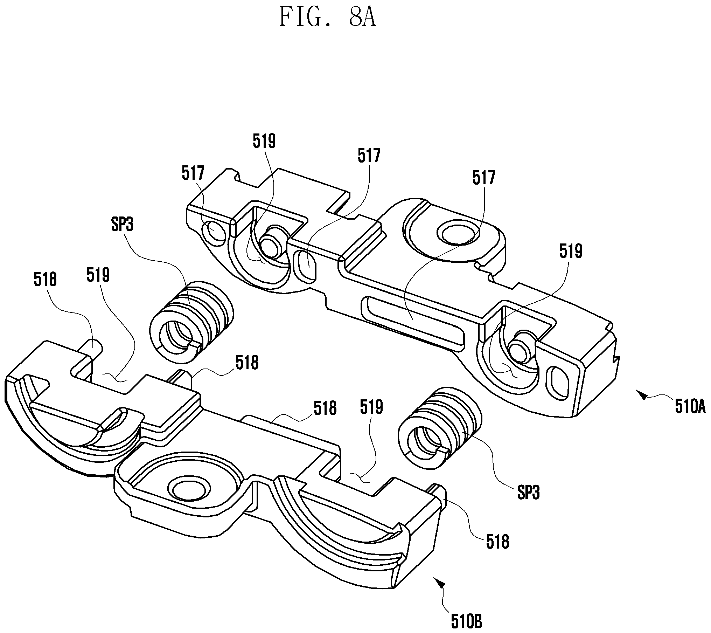

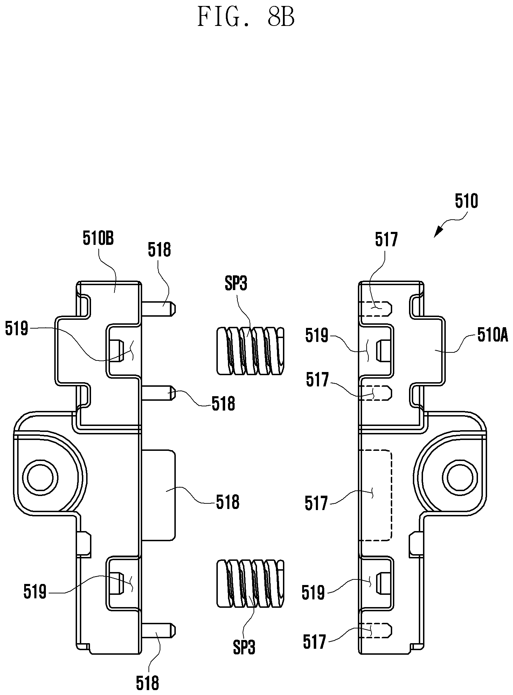

FIGS. 7A and 7B are views illustrating the coupling relationship between the first arm and the second arm. FIGS. 8A and 8B are diagrams illustrating the coupling relationship between a first rotator and a second rotator.

According to an embodiment, the first arm 610A and the second arm 610B may be coupled in various ways. In an embodiment, referring to FIGS. 7A and 7B, the first arm 610A and the second arm 610B may be coupled through the insertion of the first coupling rib 614 into the first coupling groove 613. In an embodiment, one of the first arm 610A and the second arm 610B may include the first coupling groove 613, and the remaining one of the first arm 610A and the second arm 610B may include the first coupling rib 614 inserted into the first coupling groove 613. In an embodiment, the first arm module 610 may include a first seating groove 615 into which the first elastic members SP11 and SP12 can be seated. The first seating groove 615 may include a (1-1)^{th} seating groove 615-1 into which the (1-1)^{th} elastic member SP11 can be seated, and a (1-2)^{th} seating groove 615-1 into which the (1-2)^{th} elastic member SP12 can be seated. In an embodiment, the (1-1)^{th} seating groove 615-1 may be a space between the first cam structure 611 of the first arm 610A and the second cam structure 612 of the second arm 610B. In an embodiment, the (1-2)^{th} seating groove 615-2 may be a space provided by coupling the first arm 610A and the second arm 610B. Likewise, the second arm module 620 may include the same configuration as the first arm module 610. One of the third arm 620A and the fourth arm 620B may include a second coupling groove (not illustrated) (e.g., the first coupling groove 613), and a remaining one of the third arm 620A and the fourth arm 620B may include a second coupling rib (not illustrated) (e.g., the first coupling rib 614) inserted into the second coupling groove 623. In an embodiment, the second arm module 620 may include a second seating groove (not illustrated) (e.g., the first seating groove 615) into which the first elastic members SP11 and SP12 can be seated. The second seating groove includes a (2-1)^{th} seating groove (not illustrated) (e.g., the (1-1)^{th} seating groove 615-1) into which the (2-1)^{th} elastic member SP21 can be seated, and a (2-2)^{th} seating groove (not illustrated) (e.g., the (1-2)^{th} seating groove 615-2) into which the elastic member SP22 can be seated. In an embodiment, the (2-1)^{th} seating groove may be a space between the third cam structure 621 of the third arm 620A and the fourth cam structure 622 of the fourth arm 620B. In an embodiment, the (2-2)^{th} seating groove may be a space provided by coupling the third arm 620A and the fourth arm 620B.

According to an embodiment, the first rotator 510A and the second rotator 510B may be coupled in various ways. In an embodiment, referring to FIGS. 8A and 8B, the first rotator 510A and the second rotator 510B may be coupled through the insertion of the third coupling rib 518 into the third coupling groove 517. In an embodiment, one of the first rotator 510A and the second rotator 510B may include the third coupling groove 517, and the remaining one of the first rotator 510A and the second rotator 510B may include the third coupling rib 518 inserted into the third coupling groove 517. In an embodiment, the first rotator module 510 may include at least one third seating groove 519 into which at least one third elastic member SP3 can be seated. In an embodiment, the third seating groove 519 may be a space provided by coupling the first rotator 510A and the second rotator 510B. Likewise, the second rotator module 520 may include the same configuration as the first rotator module 510. In an embodiment, one of the third rotator 520A and the fourth rotator 520B may include a fourth coupling groove (not illustrated) (e.g., the third coupling groove 517), and a remaining one of the third rotator 520A and the fourth rotator 520B may include a fourth coupling rib (not illustrated) (e.g., the third coupling rib 518) inserted into the fourth coupling groove. In an embodiment, the second rotator module 520 may include at least one fourth seating groove (e.g., the third seating groove 519) into which at least one fourth elastic member SP4 can be seated. In an embodiment, the fourth seating groove may be a space provided by coupling the third rotator 520A and the fourth rotator 520B.

The above-described method of coupling the first arm module 610, the second arm module 620, the first rotator module 510, and the second rotator module 520 is merely an example, and the disclosure may not be limited thereto. In an embodiment, the first arm module 610, the second arm module 620, the first rotator module 510, and the second rotator module 520 are coupled by various ways such as bolt-nut coupling, rivet coupling, adhesive coupling.

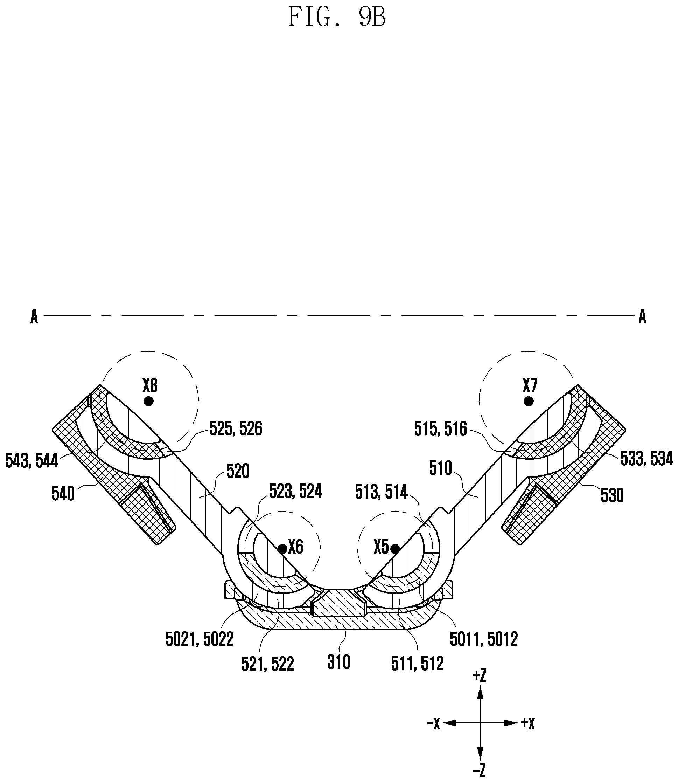

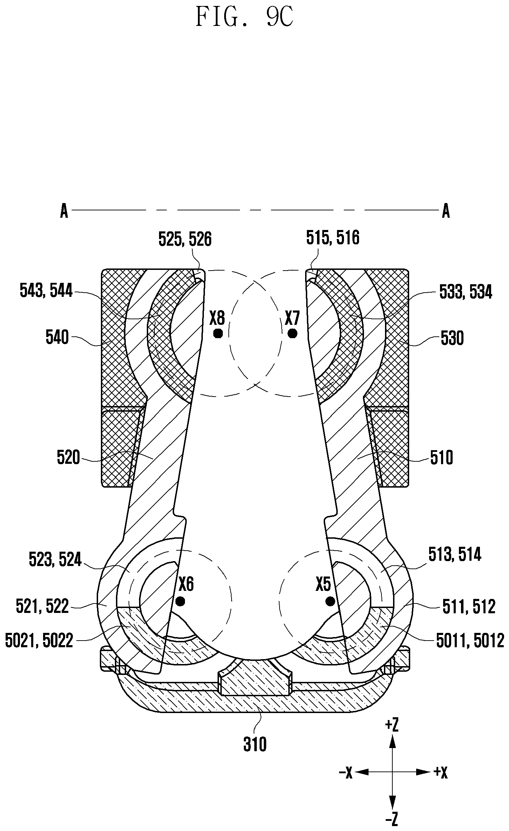

FIG. 9A is a cross-sectional view of the hinge device 320 taken along line A-A indicated in FIG. 4A when the electronic device 200 is in the unfolded state. FIG. 9B is a cross-sectional view of the hinge device 320 taken along line A-A indicated in FIG. 4A when the electronic device 200 is in the (or an) intermediate state. FIG. 9C is a cross-sectional view of the hinge device 320 taken along line A-A indicated in FIG. 4A when the electronic device 200 is in the folded state.

According to an embodiment, the first rotator module 510 may be connected to the first housing 210 via the first rotator link 530. The second rotator module 520 may be connected to the second housing 220 via the second rotator link 540. In an embodiment, referring to FIGS. 9A, 9B, and 9C, since the first housing 210 and the second housing 220 rotate while the electronic device 200 is switched to the unfolded state or the folded state (or, in other words, while its configuration is changed between the folded and unfolded states), the first rotator 510A and the second rotator 510B may rotate about the fifth rotation axis X5 and the sixth rotation axis X6, respectively. In an embodiment, depending on the degree of rotation of the first housing 210 and the second housing 220, the first rotator 510A may rotate about the seventh rotation axis X7 via the first rotator link 530, and the second rotator 510B may rotate about the eighth rotation axis X8 via the second rotator link 540.

According to an embodiment, when the electronic device 200 is in the unfolded state, the first housing 210, the second housing 220, the first hinge plate 311, and the second hinge plate 312 may form (e.g. may generally lie in) the same plane to support the flexible display 230. In an embodiment, since the first housing 210 and the second housing 220 rotate about the folding axis F while the electronic device 200 is switched (or changed) from the unfolded state to the folded state or from the folded state to the unfolded state, the first rotator module 510 and the second rotator module 520 may rotate about the fifth rotation axis X5 and the sixth rotation axis X6, respectively. Thereafter, when the angle between the first housing 210 and the second housing 220 decreases below a certain angle, the first rotator module 510 rotates about the seventh rotation axis X7 via the first rotator link 530, and the second rotator module 520 may rotate about the eighth rotation axis X8 via the second rotator link 540. When the first rotator module 510 rotates about the seventh rotation axis X7 and the electronic device 200 is in the folded state, the first rotator module 510 may not form the same plane with the first housing 210. For example, by rotating about the seventh rotation axis X7, the first rotator module 510 may be introduced into a space formed inside the first housing 210 when the electronic device 200 is in the folded state. As being seated on the first rotator module 510, the first hinge plate 311 may rotate with the first rotator module 510 about the seventh rotation axis X7, and when the electronic device 200 is in the folded state, the first hinge plate 311 may be additionally folded into the space (not illustrated) formed inside the first housing 210 and may support the folding area (e.g., the folding area 230c in FIG. 1A) of the flexible display 230 transformed into a waterdrop shape (or other curved shape). By being rotated about the eighth rotation axis X8, the second rotator module 520 may not form the same the same plane with the second housing 200 when the electronic device 200 is in the folded state. For example, by rotating about the eight rotation axis X8, the second rotator module 520 may be introduced into a space formed inside the second housing 220 when the electronic device 200 is in the folded state. As being seated on the second rotator module 520, the second hinge plate 312 may rotate with the second rotator module 520 about the eighth rotation axis X8, and when the electronic device 200 is in the folded state, the second hinge plate 312 may be additionally folded into the space formed inside the second housing 220 and may support the folding area (e.g., the folding area 230c in FIG. 1A) of the flexible display 230 transformed into a waterdrop shape (or other curved shape).

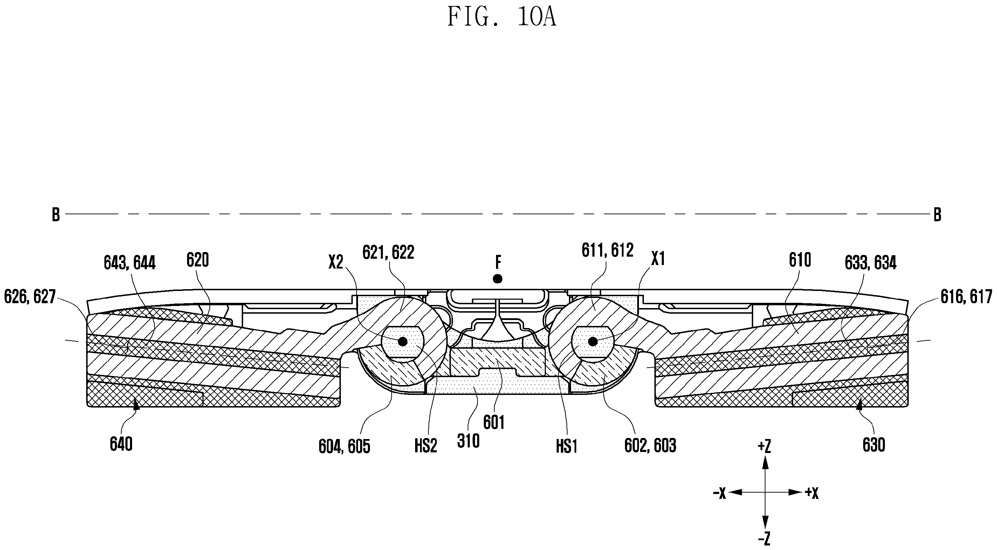

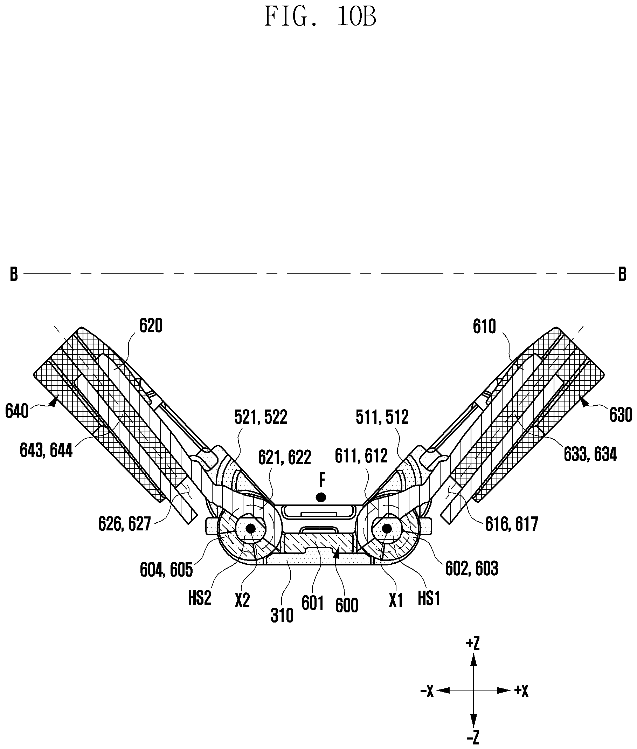

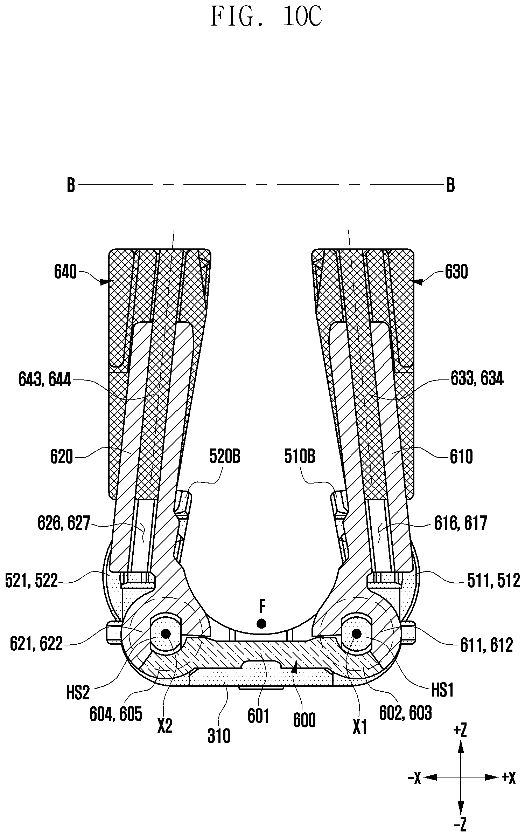

FIG. 10A is a cross-sectional view of the hinge device 320 taken along line B-B indicated in FIG. 4A when the electronic device 200 is in the unfolded state. FIG. 10B is a cross-sectional view of the hinge device 320 taken along line B-B indicated in FIG. 4A when the electronic device 200 is in the (or an) intermediate state. FIG. 10C is a cross-sectional view of the hinge device 320 taken along line B-B indicated in FIG. 4A when the electronic device 200 is in the folded state.

According to an embodiment, FIGS. 10A to 10C may be drawings that illustrate the connection relationship between the first arm module 610 and the first arm link 630 and the connection relationship between the second arm module 620 and the second arm link 640 in FIG. 4A described above.

According to an embodiment, as illustrated in FIGS. 10A to 10C, since the first housing 210 and the second housing 220 rotate about the folding axis F while the electronic device 200 is switched (or changed) from the unfolded state to the folded state or from the folded state to the unfolded state, the first arm module 610 and the second arm module 620 may rotate about the first rotation axis X1 and the second rotation axis X2, respectively. According to an embodiment, as the electronic device 200 is folded or unfolded, the first arm link 630 may be sliding motion with respect to the first arm module 610. For example, the first arm link 630 may be sliding motion with respect to the first arm module 610 in a direction perpendicular to the folding axis F. In addition, the second arm link 640 may be sliding motion with respect to the second arm module 620. For example, the second arm link 640 may be sliding motion with respect to the second arm module 620 in a direction perpendicular to the folding axis F. In an embodiment, the hinge device 320 may compensate for differences in rotation trajectories caused since the axes of the arm modules (e.g., the first rotation axis X1 and the second rotation axis X2) and the axis of the rotator modules (e.g., the fifth rotation axis X5 and the sixth rotation axis X6) through the sliding motion of the first arm link 630 with respect to the first arm module 610 and the sliding motion of the second arm link 640 with respect to the second arm module 620. The first arm module 610 may be fixed to the first housing 210 via the first arm link 630, and the first rotator module 510 may be fixed to the first housing 210 via the first rotator link 530. The first arm module 610 may rotate about the first rotation axis X1 with respect to the slide bracket 600, and the first rotator module 510 may rotate about the fifth rotation axis X5 with respect to the rotator bracket 500. The second arm module 620 may be fixed to the second housing 220 via the second arm link 640, and the second rotator module 520 may be fixed to the second housing 220 via the second rotator link 540. The second arm module 620 may rotate about the second rotation axis X2 with respect to the slide bracket 600, and the second rotator module 520 may rotate about the sixth rotation axis X6 with respect to the rotator bracket 500. Accordingly, as the first housing 210 and the second housing 220 perform a folding or unfolding operation, the first arm link 630 may move along the first arm slit 616 and the second arm slit 617 provided on the first arm module 610, and the second arm link 640 may move along the third arm slit 626 and the fourth arm slit 627 provided on the second arm module 620. Therefore, differences in rotation trajectory caused since the axes of the rotators (e.g., the fifth rotation axis X5 and the sixth rotation axis X6) and the axes of the arms (e.g., the first rotation axis X1 and the second rotation axis X2) are different from each other can be compensated for.

According to an embodiment, as illustrated in FIGS. 10A, 10B, and 10C, the slide bracket 600 may be cam-coupled with the first arm module 610 and the second arm module 620 to link the rotational motions of the first arm module 610 and the second arm module 620 to each other. The slide bracket 600 can be cam-coupled with the first arm module 610 and the second arm module 620 so that the first housing 210 and the second housing 220 can be folded or unfolded by the same angle. The first arm module 610 and the second arm module 620 may rotate together in the unfolding or folding direction of the electronic device 200 and may be linked to rotate in opposite directions. In an embodiment, as the first cam portion 602 and the first cam structure 611 and the third cam portion 604 and the third cam structure 621 rotate while being engaged with each other when the electronic device 200 is switched (or changed) from the unfolded state (e.g., the unfolded state in FIG. 10A) to the folded state (e.g., the folded state in FIG. 10A), the slide bracket 600 may move in a first direction (e.g., the + Y direction with reference to FIG. 6). When the electronic device 200 is in the (or an) intermediate state (e.g., the state in which the angle between the first housing 210 and the second housing 220 is 90 degrees), the slide bracket 600 may be in the state in which the first cam portion 602 and the first cam structure 611 of the first arm 610A are in contact with each other, the second cam portion 603 and the second cam structure 612 of the second arm 610B are in contact with each other, the third cam portion 604 and the third cam structure 621 of the third arm 620A are in contact with each other, and the fourth cam portion 605 and the fourth cam structure 622 of the fourth arm 620B are in contact with each other. Thereafter, when the electronic device 200 is switched into the folded state, the slide bracket 600 may be in the state in which the second cam portion 603 and the second cam structure 612 of the second arm 610B are engaged with each other, and the fourth cam portion 605 and the fourth cam structure 622 of the fourth arm 620B are engaged with each other.

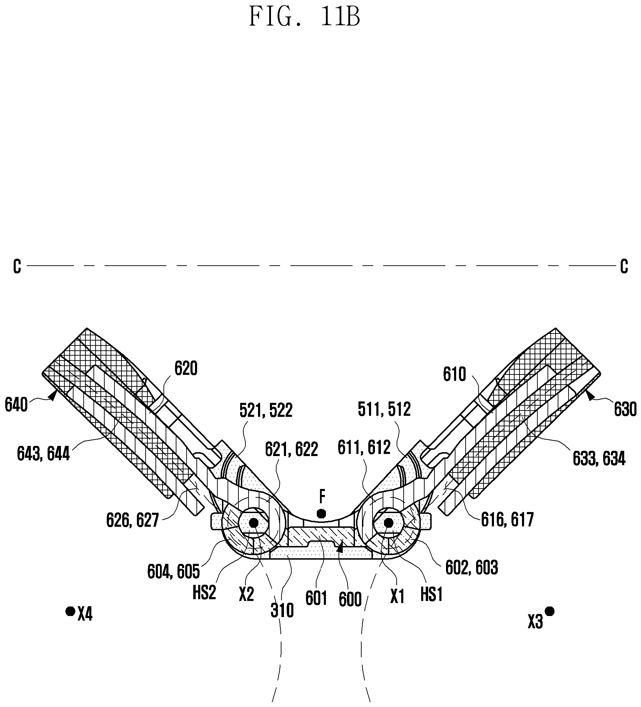

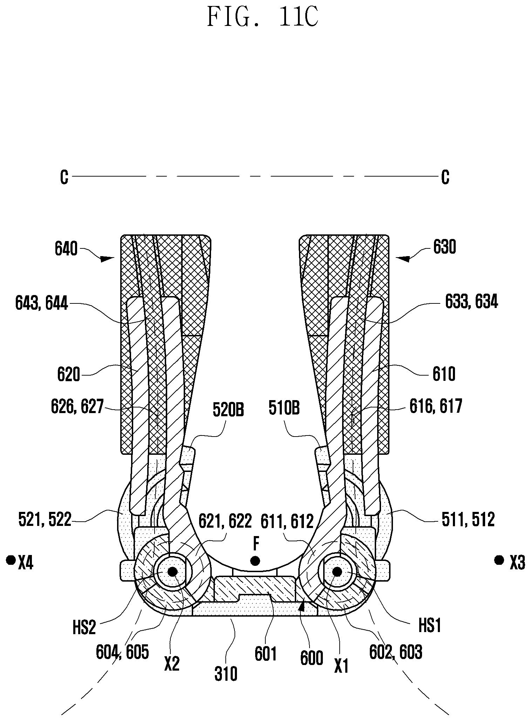

FIG. 11A is a cross-sectional view of the hinge device 320 taken along line C-C indicated in FIG. 4B when the electronic device 200 is in the unfolded state. FIG. 11B is a cross-sectional view of the hinge device 320 taken along line C-C indicated in FIG. 4B when the electronic device 200 is in the (or an) intermediate state. FIG. 11C is a cross-sectional view of the hinge device 320 taken along line C-C indicated in FIG. 4B when the electronic device 200 is in the folded state.

According to an embodiment, FIGS. 11A to 11C may be drawings that illustrate the connection relationship between the first arm module 610 and the first arm link 630 and the connection relationship between the second arm module 620 and the second arm link 640 in FIG. 4B described above. In an embodiment, the first arm link 630 may be coupled to the first arm 610A to be rotatable about the third rotation axis X3. In addition, the second arm link 640 may be coupled to the second arm 610B to be rotatable about the fourth rotation axis X4.

According to an embodiment, as illustrated in FIGS. 11A to 11C, since the first housing 210 and the second housing 220 rotate about the folding axis F while the electronic device 200 is switched from the unfolded state to the folded state or from the folded state to the unfolded state, the first arm module 610 and the second arm module 620 may rotate about the first rotation axis X1 and the second rotation axis X2, respectively. According to an embodiment, as the electronic device 200 is folded or unfolded, the first arm link 630 may rotate about the third rotation axis X3 with respect to the first arm module 610. For example, the first arm link 630 may slide with respect to the first arm module 610 along a circle with the third rotation axis X3 as its radius. In addition, the second arm link 640 may rotate about the fourth rotation axis X4 with respect to the second arm module 620. For example, the second arm link 640 may slide with respect to the second arm module 620 along a circle with the third rotation axis X4 as its radius. In other words, depending on the degree of rotation of the first housing 210 and the second housing 220, the first arm module 610 may rotate about the third rotation axis X3 via the first arm link 630, and the second arm module 620 may rotate about the fourth rotation axis X4 via the second arm link 640. In an embodiment, the hinge device 320 may compensate for differences in rotation trajectories caused since the axes of the arm modules (e.g., the first rotation axis X1 and the second rotation axis X2) and the axis of the rotator modules (e.g., the fifth rotation axis X5 and the sixth rotation axis X6) through the rotating motion of the first arm link 630 with respect to the first arm module 610 and the rotating motion of the second arm link 640 with respect to the second arm module 620. The first arm module 610 may be fixed to the first housing 210 via the first arm link 630, and the first rotator module 510 may be fixed to the first housing 210 via the first rotator link 530. The first arm module 610 may rotate about the first rotation axis X1 with respect to the slide bracket 600, and the first rotator module 510 may rotate about the fifth rotation axis X5 with respect to the rotator bracket 500. The second arm module 620 may be fixed to the second housing 220 via the second arm link 640, and the second rotator module 520 may be fixed to the second housing 220 via the second rotator link 540. The second arm module 620 may rotate about the second rotation axis X2 with respect to the slide bracket 600, and the second rotator module 520 may rotate about the sixth rotation axis X6 with respect to the rotator bracket 500. Accordingly, as the first housing 210 and the second housing 220 perform a folding or unfolding operation, the first arm link 630 may rotate along the first arm slit 616 and the second arm slit 617 provided on the first arm module 610, and the second arm link 640 may rotate along the third arm slit 626 and the fourth arm slit 627 provided on the second arm module 620. Therefore, differences in rotation trajectory caused since the axes of the rotators (e.g., the fifth rotation axis X5 and the sixth rotation axis X6) and the axes of the arms (e.g., the first rotation axis X1 and the second rotation axis X2) are different from each other can be compensated for.

According to an embodiment disclosed herein, an electronic device 200 may include a first housing 210, a second housing 220, and a hinge device 320 or 320-1 interconnecting (e.g. foldably interconnecting) the first housing and the second housing (e.g. in a foldable manner). The hinge device may include a first arm module 610 including a first arm 610A including a first cam structure 611 and a second arm 610B including a second cam structure 612, and configured to rotate about a first rotation axis X1, a second arm module 620 including a third arm 620A including a third cam structure 621 and a fourth arm 620B including a fourth cam structure 622, and configured to rotate about a second rotation axis X2, a first elastic member SP11 or SP12 (e.g. a first spring, or a first resilient member) located between the first arm and the second arm and configured to press the first arm and the second arm in opposite directions (or, in other words, to urge or bias the first and second arms apart from each other), a second elastic member SP21 or SP22 (e.g. a second spring, or a second resilient member) located between the third arm and the fourth arm and configured to press the third arm and the fourth arm in opposite directions (or, in other words, to urge or bias the third and fourth arms apart from each other), and a slide bracket 600 including a first cam portion 602 facing the first cam structure, a second cam portion 603 facing the second cam structure, a third cam portion 604 facing the third cam structure, and a fourth cam portion 605 facing the fourth cam structure, and configured to move in response to the first arm module and the second arm module (e.g. configured to move in response to rotation (or movement, or folding) of the first arm module and the second arm module, such as when a configuration of the device is changed, between a folded and an unfolded state).

The first cam structure and the second cam structure of the first arm module may be pressed toward the first cam portion and the second cam portion, respectively, via the first elastic member, and the third cam structure and the fourth cam structure of the second arm module may be pressed toward the third cam portion and the fourth cam portion, respectively, via the second elastic member. In other words, the first and second elastic members may be arranged to urge the cam structures of the first arm module and of the second arm module against (or into contact with) the respective cam portions of the slide bracket.

In addition, the slide bracket may be configured to move in a first direction as the first cam portion and the first cam structure of the first arm and the third cam portion and the third cam structure of the third arm are engaged with each other and rotate, and to move in a second direction opposite to the first direction as the second cam portion and the second cam structure of the second arm and the fourth cam portion and the fourth cam structure of the fourth arm are engaged with each other and rotate.

In addition, the first elastic member may be disposed between the first cam structure of the first arm and the second cam structure of the second arm, and the second elastic member may be disposed between the third cam structure of the third arm and the fourth cam structure of the fourth arm.

In addition, the hinge device may include a first arm link 630 slidably coupled to the first arm module and fixed to the first housing, and a second arm link 640 slidably coupled to the second arm module and fixed to the second housing.

In addition, the hinge device may include a first arm link 630 coupled to the first arm module to be rotatable about a third rotation axis X3 and fixed to the first housing, and a second arm link 640 coupled to the second arm module to be rotatable about a fourth rotation axis X4 and fixed to the second housing.

In addition, the first arm link may include a (1-1)^{th} arm fastening portion 631 facing the first arm and a (1-2)^{th} arm fastening portion 632 facing the second arm, the second arm link may include a (2-1)^{th} arm fastening portion 641 facing the third arm and a (2-2)^{th} arm fastening portion 642 facing the fourth arm, the first arm module may be configured such that, via the first elastic member, the first arm is pressed (or urged, or biased) toward the (1-1)^{th} arm fastening portion and the second arm is pressed (or urged, or biased) toward the (1-2)^{th} arm fastening portion, and the second arm module may be configured such that, via the second elastic member, the third arm is pressed (or urged, or biased) toward the (2-1)^{th} arm fastening portion and the fourth arm is pressed (or urged, or biased) toward the (2-2)^{th} arm fastening portion.

In addition, the slide bracket may include a first inclined surface 602-1 provided on the first cam portion, a second inclined surface 603-1 provided on the second cam portion, a third inclined surface 604-1 provided on the third cam portion, and a fourth inclined surface 605-1 provided on the fourth cam portion, and the first inclined surface, the second inclined surface, the third inclined surface, and the fourth inclined surface may be oriented in a direction perpendicular to the slide bracket.

In addition, the first inclined surface of the first cam portion and the third inclined surface of the third cam portion may be symmetrical with respect to a folding axis of the electronic device and may have the same shape, and the second inclined surface of the second cam portion and the fourth inclined surface of the fourth cam portion may be symmetrical with respect to the folding axis of the electronic device and may have the same shape.

In addition, the hinge device may include a rotator bracket 500, a first rotator module 510 including a first rotator 510A and a second rotator 510B fastened to the rotator bracket and configured to rotate about a fifth rotation axis X5 relative to the rotator bracket, a second rotator module 520 including a third rotator 520A and a fourth rotator 520B fastened to the rotator bracket and configured to rotate about a sixth rotation axis X6 relative to the rotator bracket, a third elastic member SP3 located between the first rotator and the second rotator and configured to press the first rotator and the second rotator in opposite directions to each other, and a fourth elastic member SP4 located between the third rotator and the fourth rotator and configured to press the third rotator and the fourth rotator in opposite directions to each other.

In addition, the hinge device may include a first rotator link 530 coupled to the first rotator module to be rotatable about a seventh rotation axis X7 and fixed to the first housing, and a second rotator link 540 coupled to the second rotator module to be rotatable about an eighth rotation axis X8 and fixed to the second housing.

In addition, the first rotator link may include a (1-1)^{th} rotator fastening portion 531 facing the first rotator and a (1-2)^{th} rotator fastening portion 532 facing the second rotator, the second rotator link may include a (2-1)^{th} rotator fastening portion 541 facing the third rotator and a (2-2)^{th} rotator fastening portion 542 facing the fourth rotator, the first rotator module may be configured such that, via the third elastic member, the first rotator is pressed toward the (1-1)^{th} rotator fastening portion and the second rotator is pressed toward the (1-2)^{th} rotator fastening portion, and the second rotator module may be configured such that, via the fourth elastic member, the third rotator is pressed toward the (2-1)^{th} rotator fastening portion and the fourth rotator is pressed toward the (2-2)^{th} rotator fastening portion.

In addition, the first arm module may include a first coupling groove 613 which is provided on one of the first arm and the second arm, a first coupling rib 614 which is provided on a remaining one of the first arm and the second arm and is inserted into the first coupling groove, and a first seating groove 615 which is provided on the first arm and the second arm and into which the first elastic member is seated, and the second arm module may include a second coupling groove which is provided on one of the third arm and the fourth arm, a second coupling rib which is provided on a remaining one of the third arm and the fourth arm and is inserted into the second coupling groove, and a second seating groove which is provided on the third arm and the fourth arm and into which the first elastic member is seated.

In addition, the first rotator module may include a third coupling groove 517 which is provided on one of the first rotator and the second rotator, a third coupling rib 518 which is provided on a remaining one of the first rotator and the second rotator and is inserted into the third coupling groove, and a third seating groove 519 which is provided on the first arm and the second arm and into which the third elastic member is seated, and the second rotator module may include a fourth coupling groove which is provided on one of the third rotator and the fourth rotator, a fourth coupling rib which is provided on a remaining one of the third rotator and the fourth rotator and is inserted into the fourth coupling groove, and a fourth seating groove which is provided on the first rotator and the second rotator and into which the fourth elastic member is seated.

In addition, the hinge device may include a first shaft HS1 inserted into the first arm module such that the first arm module rotates about the first rotation axis, and a second shaft HS2 inserted into the second arm module such that the second arm module rotates about the second rotation axis.

According to an embodiment, A hinge device 320, 320-1, or HA, which foldably interconnects a first housing 210 and a second housing 220 of an electronic device 200, may include a first arm module 610 including a first arm 610A including a first cam structure 611 and a second arm 610B including a second cam structure 612, and configured to rotate about a first rotation axis X1, a second arm module 620 including a third arm 620A including a third cam structure 621 and a fourth arm 620B including a fourth cam structure 622, and configured to rotate about a second rotation axis X2, a first elastic member SP11 or SP12 located between the first arm and the second arm and configured to press the first arm and the second arm in opposite directions, a second elastic member SP21 or SP21 located between the third arm and the fourth arm and configured to press the third arm and the fourth arm in opposite directions, and a slide bracket 600 including a first cam portion 602 facing the first cam structure, a second cam portion 603 facing the second cam structure, a third cam portion 604 facing the third cam structure, and a fourth cam portion 605 facing the fourth cam structure, and configured to move in response to the first arm module and the second arm module. The first cam structure and the second cam structure of the first arm module may be pressed toward the first cam portion and the second cam portion, respectively, via the first elastic member, and the third cam structure and the fourth cam structure of the second arm module may be pressed toward the third cam portion and the fourth cam portion, respectively, via the first elastic member.

In addition, the slide bracket may be configured to move in a first direction as the first cam portion and the first cam structure of the first arm and the third cam portion and the third cam structure of the third arm are engaged with each other and rotate, and to move in a second direction opposite to the first direction as the second cam portion and the second cam structure of the second arm and the fourth cam portion and the fourth cam structure of the fourth arm are engaged with each other and rotate.

In addition, the first elastic member may be disposed between the first cam structure of the first arm and the second cam structure of the second arm, and the second elastic member may be disposed between the third cam structure of the third arm and the fourth cam structure of the fourth arm.

In addition, the hinge device may further include a first arm link 630 slidably coupled to the first arm module and fixed to the first housing, and a second arm link 640 slidably coupled to the second arm module and fixed to the second housing. The first arm link may include a (1-1)^{th} arm fastening portion 631 facing the first arm and a (1-2)^{th} arm fastening portion 632 facing the second arm, the second arm link may include a (2-1)^{th} arm fastening portion 641 facing the third arm and a (2-2)^{th} arm fastening portion 642 facing the fourth arm, the first arm module may be configured such that, via the first elastic member, the first arm is pressed toward the (1-1)^{th} arm fastening portion and the second arm is pressed toward the (1-2)^{th} arm fastening portion, and the second arm module may be configured such that, via the second elastic member, the third arm is pressed toward the (2-1)^{th} arm fastening portion and the fourth arm is pressed toward the (2-2)^{th} arm fastening portion.

In addition, the slide bracket may include a first inclined surface 602-1 provided on the first cam portion, a second inclined surface 603-1 provided on the second cam portion, a third inclined surface 604-1 provided on the third cam portion, and a fourth inclined surface 605-1 provided on the first cam portion, and the first inclined surface, the second inclined surface, the third inclined surface, and the fourth inclined surface may be oriented in a direction perpendicular to the slide bracket.

## Claims

1. An electronic device (200) comprising:
a first housing (210);
a second housing (220); and
a hinge device (320, 320-1) foldably interconnecting the first housing and the second housing,
wherein the hinge device comprises:
a first arm module (610) comprising a first arm (610A) comprising a first cam structure (611) and a second arm (610B) comprising a second cam structure (612), and configured to rotate about a first rotation axis (X1);
a second arm module (620) comprising a third arm (620A) comprising a third cam structure (621) and a fourth arm (620B) comprising a fourth cam structure (622), and configured to rotate about a second rotation axis (X2);
a first elastic member (SP11, SP12) located between the first arm and the second arm and configured to press the first arm and the second arm in opposite directions;
a second elastic member (SP21, SP22) located between the third arm and the fourth arm and configured to press the third arm and the fourth arm in opposite directions; and
a slide bracket (600) comprising a first cam portion (602) facing the first cam structure, a second cam portion (603) facing the second cam structure, a third cam portion (604) facing the third cam structure, and a fourth cam portion (605) facing the fourth cam structure, and configured to move in response to the first arm module and the second arm module.

2. The electronic device of claim 1, wherein the first cam structure and the second cam structure of the first arm module are pressed toward the first cam portion and the second cam portion, respectively, via the first elastic member, and
wherein the third cam structure and the fourth cam structure of the second arm module are pressed toward the third cam portion and the fourth cam portion, respectively, via the second elastic member.

3. The electronic device of claim 1, wherein the slide bracket is configured to:
move in a first direction as the first cam portion and the first cam structure of the first arm and the third cam portion and the third cam structure of the third arm are engaged with each other and rotate; and
move in a second direction opposite to the first direction as the second cam portion and the second cam structure of the second arm and the fourth cam portion and the fourth cam structure of the fourth arm are engaged with each other and to rotate.

4. The electronic device of claim 1, wherein the first elastic member is disposed between the first cam structure of the first arm and the second cam structure of the second arm, and
wherein the second elastic member is disposed between the third cam structure of the third arm and the fourth cam structure of the fourth arm.

5. The electronic device of claim 1, wherein the hinge device further comprises:
a first arm link (630) slidably coupled to the first arm module and fixed to the first housing; and
a second arm link (640) slidably coupled to the second arm module and fixed to the second housing.

6. The electronic device of claim 1, wherein the hinge device further comprises:
a first arm link (630) coupled to the first arm module to be rotatable about a third rotation axis (X3) and fixed to the first housing; and
a second arm link (640) coupled to the second arm module to be rotatable about a fourth rotation axis (X4) and fixed to the second housing.

7. The electronic device of claim 5 or 6, wherein the first arm link comprises a (1-1)^{th} arm fastening portion (631) facing the first arm and a (1-2)^{th} arm fastening portion (632) facing the second arm,
wherein the second arm link comprises a (2-1)^{th} arm fastening portion (641) facing the third arm and a (2-2)^{th} arm fastening portion (642) facing the fourth arm,
wherein the first arm module is configured such that, via the first elastic member, the first arm is pressed toward the (1-1)^{th} arm fastening portion and the second arm is pressed toward the (1-2)^{th} arm fastening portion, and
wherein the second arm module is configured such that, via the second elastic member, the third arm is pressed toward the (2-1)^{th} arm fastening portion and the fourth arm is pressed toward the (2-2)^{th} arm fastening portion.

8. The electronic device of claim 1, wherein the slide bracket comprises a first inclined surface (602-1) formed on the first cam portion, a second inclined surface (603-1) formed on the second cam portion, a third inclined surface (604-1) formed on the third cam portion, and a fourth inclined surface (605-1) formed on the fourth cam portion, and
wherein the first inclined surface, the second inclined surface, the third inclined surface, and the fourth inclined surface are oriented in a direction perpendicular to the slide bracket.

9. The electronic device of claim 8, wherein the first inclined surface of the first cam portion and the third inclined surface of the third cam portion are symmetrical with respect to a folding axis of the electronic device and have a same shape, and
wherein the second inclined surface of the second cam portion and the fourth inclined surface of the fourth cam portion are symmetrical with respect to the folding axis of the electronic device and have a same shape.

10. The electronic device of claim 1, wherein the hinge device further comprises:
a rotator bracket (500);
a first rotator module (510) comprising a first rotator (510A) and a second rotator (510B) fastened to the rotator bracket and configured to rotate about a fifth rotation axis (X5) relative to the rotator bracket;
a second rotator module (520) comprising a third rotator (520A) and a fourth rotator (520B) fastened to the rotator bracket and configured to rotate about a sixth rotation axis (X6) relative to the rotator bracket;
a third elastic member (SP3) located between the first rotator and the second rotator and configured to press the first rotator and the second rotator in opposite directions to each other; and
a fourth elastic member (SP4) located between the third rotator and the fourth rotator and configured to press the third rotator and the fourth rotator in opposite directions to each other.

11. The electronic device of claim 10, wherein the hinge device further comprises:
a first rotator link (530) coupled to the first rotator module to be rotatable about a seventh rotation axis (X7) and fixed to the first housing; and
a second arm link (540) coupled to the second rotator module to be rotatable about an eighth rotation axis (X8) and fixed to the second housing.

12. The electronic device of claim 11, wherein the first rotator link comprises a (1-1)^{th} rotator fastening portion (531) facing the first rotator and a (1-2)^{th} rotator fastening portion (532) facing the second rotator,
wherein the second rotator link comprises a (2-1)^{th} rotator fastening portion (541) facing the third rotator and a (2-2)^{th} rotator fastening portion (542) facing the fourth rotator,
wherein the first rotator module is configured such that, via the third elastic member, the first rotator is pressed toward the (1-1)^{th} rotator fastening portion and the second rotator is pressed toward the (1-2)^{th} rotator fastening portion, and
wherein the second rotator module is configured such that, via the fourth elastic member, the third rotator is pressed toward the (2-1)^{th} rotator fastening portion and the fourth rotator is pressed toward the (2-2)^{th} rotator fastening portion.

13. The electronic device of claim 1, wherein the first arm module comprises a first coupling groove (613) which is provided on one of the first arm and the second arm, a first coupling rib (614) which is provided on a remaining one of the first arm and the second arm and is inserted into the first coupling groove, and a first seating groove (615) which is provided on the first arm and the second arm and into which the first elastic member is seated, and
wherein the second arm module comprises a second coupling groove which is provided on one of the third arm and the fourth arm, a second coupling rib which is provided on a remaining one of the third arm and the fourth arm and is inserted into the second coupling groove, and a second seating groove which is provided on the third arm and the fourth arm and into which the first elastic member is seated.

14. The electronic device of claim 10, wherein the first rotator module comprises a third coupling groove (517) which is provided on one of the first rotator and the second rotator, a third coupling rib (518) which is provided on a remaining one of the first rotator and the second rotator and is inserted into the third coupling groove, and a third seating groove (519) which is provided on the first arm and the second arm and into which the third elastic member is seated, and
wherein the second rotator module comprises a fourth coupling groove which is provided on one of the third rotator and the fourth rotator, a fourth coupling rib which is provided on a remaining one of the third rotator and the fourth rotator and is inserted into the fourth coupling groove, and a fourth seating groove which is provided on the first rotator and the second rotator and into which the fourth elastic member is seated.

15. A hinge device (320, 320-1, HA) that foldably interconnects a first housing (210) and a second housing (220) of an electronic device (200), the hinge device comprising:
a first arm module (610) comprising a first arm (610A) comprising a first cam structure (611) and a second arm (610B) comprising a second cam structure (612), and configured to rotate about a first rotation axis (X1);
a second arm module (620) comprising a third arm (620A) comprising a third cam structure (621) and a fourth arm (620B) comprising a fourth cam structure (622), and configured to rotate about a second rotation axis (X2);
a first elastic member (SP11, SP12) located between the first arm and the second arm and configured to press the first arm and the second arm in opposite directions;
a second elastic member (SP21, SP21) located between the third arm and the fourth arm and configured to press the third arm and the fourth arm in opposite directions; and
a slide bracket (600) comprising a first cam portion (602) facing the first cam structure, a second cam portion (603) facing the second cam structure, a third cam portion (604) facing the third cam structure, and a fourth cam portion (605) facing the fourth cam structure, and configured to move in response to the first arm module and the second arm module,
wherein the first cam structure and the second cam structure of the first arm module are pressed toward the first cam portion and the second cam portion, respectively, via the first elastic member, and
wherein the third cam structure and the fourth cam structure of the second arm module are pressed toward the third cam portion and the fourth cam portion, respectively, via the first elastic member.
